(19)

Europäisches
Patentamt
European
Patent Office
Office européen
des brevets

(11) **EP 4 450 333 A1**

(12) **EUROPEAN PATENT APPLICATION**
published in accordance with Art. 153(4) EPC

(43) Date of publication:
**23.10.2024  Bulletin 2024/43**

(21) Application number: **22907508.0**

(22) Date of filing: **15.12.2022**

(51) International Patent Classification (IPC):
*B60R 16/04* (2006.01)       *B60L 58/10* (2019.01)
*B60R 16/023* (2006.01)      *G01R 31/367* (2019.01)
*G01R 31/371* (2019.01)      *G01R 31/382* (2019.01)
*G01R 31/385* (2019.01)      *G01R 31/389* (2019.01)
*G01R 31/392* (2019.01)      *H01M 10/44* (2006.01)
*H01M 10/48* (2006.01)       *H02J 7/00* (2006.01)
*H02J 13/00* (2006.01)

(52) Cooperative Patent Classification (CPC):
B60L 58/10; B60R 16/023; B60R 16/04;
G01R 31/367; G01R 31/371; G01R 31/382;
G01R 31/385; G01R 31/389; G01R 31/392;
H01M 10/44; H01M 10/48; H02J 7/00; H02J 13/00

(86) International application number:
**PCT/JP2022/046209**

(87) International publication number:
**WO 2023/112985 (22.06.2023 Gazette 2023/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **16.12.2021   JP 2021204565
16.12.2021   JP 2021204566**

(71) Applicants:
• **FURUKAWA ELECTRIC CO., LTD.**
**Tokyo 100-8322 (JP)**
• **Furukawa Automotive Systems Inc.**
**Inukami-gun, Shiga 522-0242 (JP)**

(72) Inventors:
• **IMAMURA Takahiro**
**Inukami-gun, Shiga 522-0242 (JP)**
• **INOUE Kiyoshi**
**Inukami-gun, Shiga 522-0242 (JP)**
• **ASANO Minoru**
**Inukami-gun, Shiga 522-0242 (JP)**
• **UOTSU Atsushi**
**Inukami-gun, Shiga 522-0242 (JP)**
• **UEDA Tetsuya**
**Inukami-gun, Shiga 522-0242 (JP)**
• **SATO Katsuyoshi**
**Inukami-gun, Shiga 522-0242 (JP)**

(74) Representative: **Horn Kleimann Waitzhofer
Schmid-Dreyer
Patent- und Rechtsanwälte PartG mbB
Theresienhöhe 12
80339 München (DE)**

(54) **BATTERY STATUS DETECTION DEVICE, INFORMATION PROCESSING SYSTEM, AND DATA COLLECTION METHOD**

(57)     A battery state detection device (10) comprises a sensor (22), a communicator (32), and an estimator (23). The sensor (22) measures at least one of a voltage, a current, and a temperature of a rechargeable battery (4) installed to a vehicle (2). The communicator (32) is configured to obtain reference information relating to battery state detection from an external device (40). The estimator (23) is configured to estimate a state of the rechargeable battery (4) based on a measured value of the sensor (22). The estimator (23) is configured to correct at least one of an estimation equation and a parameter based on the reference information.

**EP 4 450 333 A1**

FIG. 1

**Description**

Technical Field

The technology disclosed in the present application relates to a battery state detection device, an information processing system, and a data collection method.

Background Art

Patent Literature 1 describes a secondary-battery charging control device. The secondary-battery charging control device determines the possibility of starting the secondary battery in the future and notifies the user of the determination result via a portable terminal.
Patent Literature 2 describes a rechargeable-battery state detection device that transmits usage pattern information to a cloud server. The cloud server obtains SOH based on the usage pattern information and supplies it to the rechargeable-battery state detection device.

Citation List

Patent Literature

   Patent Literature 1: Japanese Laid-Open Patent Publication No. 2015-182518
   Patent Literature 2: Japanese Laid-Open Patent Publication No. 2021-093359

Summary of Invention

Technical Problem

The secondary-battery charging control device described in Patent Literature 1, however, does not have a configuration for using information from outside the vehicle. The rechargeable-battery state detection device described in Patent Literature 2 has a configuration for transmitting usage pattern information to a cloud server but does not have a configuration for obtaining information such as usage pattern information from outside the vehicle for use in battery state detection. In order to improve the accuracy of the battery state detection, it is preferable to use information from external sources.
An object of the technology disclosed in the present application is, for example, to improve the accuracy of detecting a state of a rechargeable battery.

Solution to Problem

In accordance with a first aspect, a battery state detection device comprises a sensor, a communicator, and an estimator. The sensor measures at least one of a voltage, a current, and a temperature of a rechargeable battery installed to a vehicle. The communicator is configured to obtain reference information relating to battery state detection from an external device. The estimator is configured to estimate a state of the rechargeable battery based on a measured value of the sensor. The estimator is configured to correct at least one of an estimation equation and a parameter based on the reference information.
With the battery state detection device according to the first aspect, since the estimator corrects at least one of the estimation equation and the parameter based on the reference information obtained from the external device, the reference information can be updated depending on the rechargeable battery via the external device, enabling the accuracy of the battery state detection to be improved.
In accordance with a second aspect, in the battery state detection device according to the first aspect, the reference information includes at least one of battery identification information enabling the rechargeable battery to be identified, electrical component information relating to an electrical component which has been custom-installed to the vehicle, user usage information relating to at least one of vehicle usage frequency and a vehicle usage method of a user, and history information relating to at least one of replacement history and reconnection history of the rechargeable battery.
With the battery state detection device according to the second aspect, it is possible to further improve the accuracy of the battery state detection by using at least one of the battery identification information, the electrical component information, the user usage information, and the history information.

In accordance with a third aspect, the battery state detection device according to the first or second aspect further comprises a discharge circuit. The estimator is configured to obtain a component constituting an equivalent circuit of the rechargeable battery based on a response when a pulsed current flows through the discharge circuit. The estimator is configured to estimate the state of the rechargeable battery based on the component constituting the equivalent circuit.

With the battery state detection device according to the third aspect, it is possible to improve the accuracy of the estimation of battery state information by the estimation based on an equivalent circuit model which utilizes pulse discharge.

In accordance with a fourth aspect, in the battery state detection device according to the third aspect, the reference information includes battery identification information enabling the rechargeable battery to be identified. The estimator is configured to correct the component constituting the equivalent circuit based on the battery identification information.

With the battery state detection device according to the fourth aspect, it is possible to further improve the accuracy of the estimation of the battery state information by correcting the component constituting the equivalent circuit using the battery identification information.

In accordance with a fifth aspect, in the battery state detection device according to any one of the first to fourth aspects, the reference information includes electrical component information relating to an electrical component which has been custom-installed to the vehicle. The estimator is configured to correct the estimation process information relating to the estimation of the state of the rechargeable battery based on the electrical component information.

With the battery state detection device according to the fifth aspect, it is possible to further improve the accuracy of the estimation of the battery state information by correcting the estimated process information using the electrical component information.

In accordance with a sixth aspect, in the battery state detection device according to the third or fourth aspect, the reference information includes user usage information relating to at least one of vehicle usage frequency of a user and a vehicle usage method of the user. The estimator is configured to select, based on the user usage information, a correction coefficient for correcting the component constituting the equivalent circuit.

With the battery state detection device according to the sixth aspect, the accuracy of estimation of the battery state information can be further improved by selecting the correction coefficient which corrects the equivalent circuit using user usage information.

In accordance with a seventh aspect, in the battery state detection device according to the third or fourth aspect, the reference information includes history information indicating at least one of replacement history and reconnection history of the rechargeable battery. The estimator is configured to correct, based on the history information, an estimation process or an estimation result which uses the component constituting the equivalent circuit.

With the battery state detection device according to the seventh aspect, it is possible to further improve the accuracy of the estimation of the battery state information by correcting, based on the history information, the estimation process or the estimation result which uses the component constituting the equivalent circuit.

In accordance with an eighth aspect, in the battery state detection device according to any one of the first to seventh aspects, the communicator is provided separately from at least one of the sensor and estimator and is configured to be detachably attached to at least one of the sensor and the estimator.

With the battery state detection device according to the eighth aspect, it is possible to attach the communicator to a configuration which does not have a communicator by providing the communicator separately from at least one of the sensor and the estimator, which improves convenience.

In accordance with a ninth aspect, the battery state detection device according to any one of the first to eighth aspects further comprises a battery state detection unit and a communication unit. The battery state detection unit is configured to detect battery state information indicating the state of the rechargeable battery. The battery state detection unit includes the sensor and the estimator. The communication unit includes a communicator and a first connection part. The communicator includes an information communicator and a wireless communicator. The first connection part is configured to be attached to the battery state detection device and is electrically connected to the battery state detection device in a state where the first connection part is attached to the battery state detection device. The information communicator is configured to obtain the battery state information from the battery state detection unit via the first connection part. The wireless communicator is configured to wirelessly transmit the battery state information obtained by the information communicator to the external device.

With the battery state detection device according to the ninth aspect, since the first connection part is configured to be detachably attached to the battery state detection unit, the communication unit can be attached to the battery state detection unit via the first connection part. Therefore, the communication unit can be attached to an existing battery state detection device, thereby improving the convenience of the battery state detection device while reducing an increase in cost.

In accordance with a tenth aspect, in the battery state detection device according to the ninth aspect, the information communicator includes a first wired communicator and a second wired communicator. The first wired communicator is configured to receive the battery state information from the battery state detection unit via the first connection part by wired communication. The second wired communicator is configured to transmit the battery state information to the in-vehicle controller of the vehicle by wired communication.

With the battery state detection device according to the tenth aspect, it is possible to transmit the battery state information not only to the external device but also to the in-vehicle controller. This enables the battery state information to be transmitted to the external device while maintaining the control of the vehicle using the battery state information.

In accordance with an eleventh aspect, the battery state detection device according to the tenth aspect further comprises a second connection part. The second connection part is electrically connectable to the in-vehicle controller. The second wired communicator is configured to transmit the battery state information to the in-vehicle controller via the second connection part by wired communication.

With the battery state detection device according to the eleventh aspect, the second connection part enables the connection with the in-vehicle controller to be reliably realized.

In accordance with a twelfth aspect, in the battery state detection device according to the eleventh aspect, a shape of the second connection part is complementary to a shape of the first connection part.

With the battery state detection device according to the twelfth aspect, a part (e.g., a harness) which is connectable with the second connection part can be directly connected to the battery state detection unit. Therefore, it is possible to make both a configuration in which a wire harness of the vehicle is directly connected to the battery state detection unit and a configuration in which the wire harness of the vehicle is connected to the battery state detection unit via the communication unit compatible.

In accordance with a thirteenth aspect, in the battery state detection device according to any one of the tenth to twelfth aspects, the first wired communicator is configured to receive the battery state information from the battery state detection unit via the first connection part by wired communication using the first protocol. The second wired communicator is configured to transmit the battery state information to the in-vehicle controller by wired communication using a second protocol different from the first protocol.

With the battery state detection device according to the thirteenth aspect, it is possible to transmit and receive information relating to the battery state detection between networks with different protocols.

In accordance with a fourteenth aspect, in the battery state detection device according to any one of the tenth to thirteenth aspects, the wireless communicator is configured to wirelessly receive the reference information relating to the battery state detection from the external device. The information communicator transmits the reference information received by the wireless communicator to at least one of the in-vehicle controller and the battery state detection unit.

With the battery state detection device according to the fourteenth aspect, it is possible to update information depending on the rechargeable battery and then to improve the accuracy of the battery state information by transmitting the reference information obtained from the external device to at least one of the in-vehicle controller and the battery state detection unit.

In accordance with a fifteenth aspect, in the battery state detection device according to any one of the ninth to fourteenth aspects, the wireless communicator is configured to perform wireless communication using at least one of a Bluetooth standard and a Wi-Fi standard.

With the battery state detection device according to the fifteenth aspect, it is possible to use a highly versatile user terminal such as a smartphone and a tablet computer as the external device. Thus, the convenience of the battery state detection device is improved.

In accordance with a sixteenth aspect, in the battery state detection device according to any one of the ninth to fifteenth aspects, the wireless communicator is configured to upload the battery state information obtained by the information communicator to a server.

With the battery state detection device according to the sixteenth aspect, it is possible to effectively utilize the battery state information to improve the accuracy of the battery state detection by analyzing the battery state information obtained from a plurality of battery state detection devices in the server.

In accordance with a seventeenth aspect, the battery state detection device according to any one of the ninth to sixteenth aspects further comprises a housing which houses the information communicator. The housing includes a rotation stopper contactable with a side of the rechargeable battery.

With the battery state detection device according to the seventeenth aspect, it is possible to stabilize the posture of the communication unit with respect to the rechargeable battery.

In accordance with an eighteenth aspect, in the battery state detection device according to any one of the ninth to seventeenth aspects, the battery state detection unit includes a battery connection part attachable to a terminal of a rechargeable battery. The sensor includes a voltage sensor, a current sensor, and a temperature sensor. The voltage sensor is configured to measure a voltage of the rechargeable battery. The current sensor is configured to measure a current of the rechargeable battery. The temperature sensor is configured to measure a temperature of the rechargeable battery. The estimator is configured to estimate the state of the rechargeable battery based on at least one of a measured voltage of the voltage sensor, a measured current of the current sensor, and a measured temperature of the temperature sensor. The information communicator of the communication unit is configured to obtain, as the battery state information, at least one of the measured voltage, the measured current, the measured temperature, and an estimation result of the estimator via the first connection part.

With the battery state detection device according to the eighteenth aspect, even if the battery state detection unit does not have a wireless transmission function, by connecting the communication unit to the battery state detection unit, the battery state information can be transmitted wirelessly to the external device via the communication unit. Therefore, the communication unit can improve the convenience of the battery state detection unit.

In accordance with a nineteenth aspect, in the battery state detection device according to the eighteenth aspect, the battery state detection unit includes a discharge circuit. The estimator is configured to obtain the component constituting the equivalent circuit of the rechargeable battery based on a response when a pulsed current flows through the discharge circuit. The estimator is configured to estimate the state of the rechargeable battery based on the component constituting the equivalent circuit.

With the battery state detection device according to the nineteenth aspect, it is possible to improve the accuracy of the estimation of the battery state information by the estimation based on an equivalent circuit model which utilizes pulse discharge.

In accordance with a twentieth aspect, in the battery state detection device according to the eighteenth or nineteenth aspect, the wireless communicator is configured to wirelessly receive reference information relating to the battery state detection from the external device. The estimator is configured to correct estimation process information relating to an estimation of the state of the rechargeable battery based on the reference information.

With the battery state detection device according to the twentieth aspect, it is possible to correct the estimated processing information depending on the rechargeable battery and then to improve the accuracy of detecting the battery state information by using the reference information.

In accordance with a twenty-first aspect, an information processing system comprises a battery state detection device according to any one of the first to twentieth aspects, a user terminal configured to wirelessly communicate with the communicator of the battery state detection device, and a server configured to be connected to the battery state detection device and the user terminal via the Internet.

With the information processing system according to the twenty-first aspect, since the communicator and the user terminal are connected to the server via the Internet, the battery state information can be transmitted to the server and then effectively utilized.

In accordance with a twenty-second aspect, a data collection method comprises: a step of obtaining battery state information using a battery state detection device configured to detect a state of a rechargeable battery installed to a vehicle; a step of transmitting the battery state information to a user terminal using the battery state detection device; a step of inquiring of a user, using the user terminal, whether or not to permit uploading of the battery state information; and a step of uploading the battery state information to a server using the user terminal in a case where the user permits the uploading.

With the data collection method according to the twenty-second aspect, since the user terminal is connected to the server via the Internet, the battery state information can be transmitted to the server and then effectively utilized.

Advantageous Effects of Invention

With the technology disclosed in the present application, it is possible to improve the accuracy of detecting the state of the rechargeable battery.

Brief Description of Drawings

FIG. 1 is a schematic block diagram of an information processing system including a battery state detection device.
FIG. 2 is a schematic block diagram of the battery state detection device and an external device.
FIG. 3 is an exploded perspective view of the battery state detection device.
FIG. 4 is an example of an equivalent circuit diagram of a rechargeable battery.
FIG. 5 is a diagram showing constants for each battery size.
FIG. 6 is a diagram showing correction coefficients for each usage pattern.
FIG. 7 is a diagram showing standard values of a dark current for each model and each grade of a vehicle.
FIG. 8 is a diagram showing standard values of the dark current for each electrical component.
FIG. 9 is a diagram showing relationship between the dark current and voltage drop values for each battery type.
FIG. 10 is a flowchart of the operation of the battery state detection device and an information processing system.

FIG. 11 is a flowchart of the operation of the battery state detection device and the information processing system.
FIG. 12 is a schematic block diagram of the battery state detection device in accordance with a modification and an external device.
FIG. 13 is a schematic block diagram of the battery state detection device in accordance with a modification and the external device.
FIG. 14 is a schematic block diagram of the battery state detection device in accordance with a modification and the external device.
FIG. 15 is a schematic block diagram of the battery state detection device in accordance with a modification and the external device.

Description of Embodiments

Embodiments will be described below with reference to the drawings. In the drawings, the same reference signs indicate corresponding or identical configurations.

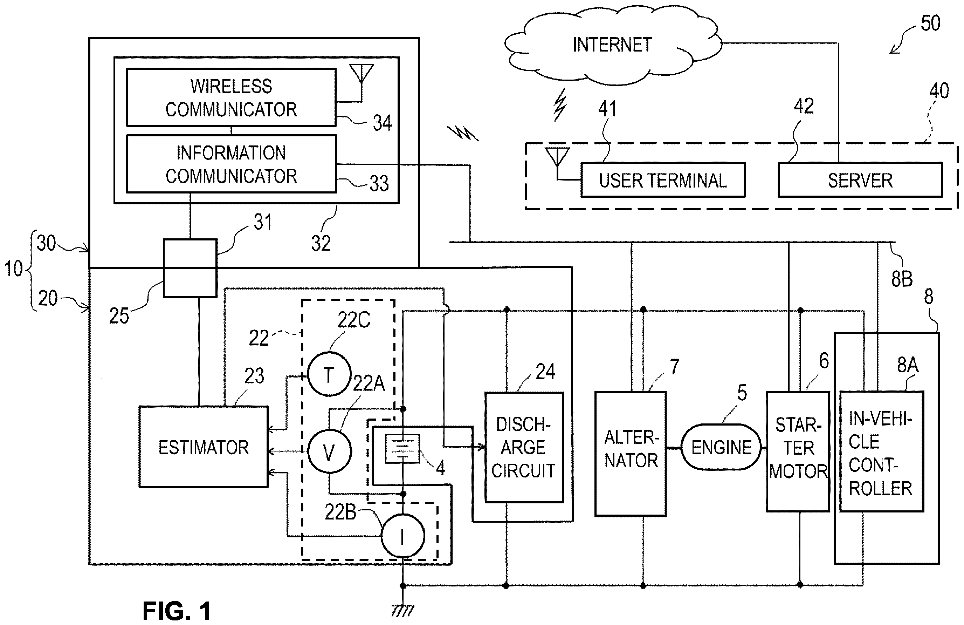

As shown in FIG. 1, a vehicle 2 comprises a rechargeable battery 4, an engine 5, a starter motor 6, an alternator 7, a load 8, and a battery state detection device 10. In the present embodiment, the engine 5 is configured to generate driving force of the vehicle 2 and includes, for example, an internal combustion engine such as a gasoline engine and a diesel engine. However, the vehicle 2 may be a hybrid vehicle with an engine (internal combustion engine) and a vehicle drive motor as a power source, as well as an electric vehicle or fuel cell vehicle with a vehicle drive motor as a power source. Thus, for example, the vehicle 2 may comprise a battery for driving a vehicle in addition to the rechargeable battery 4. The vehicle 2 is not limited to the exemplified vehicles.

The examples of the rechargeable battery 4 include a lead-acid battery, a nickel-cadmium battery, a nickel-metal hydride battery, and a lithium-ion battery. The rechargeable battery 4 is configured to be electrically connected to the starter motor 6, the alternator 7, and the load 8. The starter motor 6 is coupled to the engine 5 so as to start the engine 5. The starter motor 6 is powered by electricity supplied from the rechargeable battery 4. The alternator 7 is coupled to the engine 5 so as to generate electricity using the driving force generated by engine 5. The alternator 7 includes, for example, an AC circuit which generates AC power using the driving force of the engine 5 and a rectifier circuit which converts the AC power to DC power. The DC power generated by the alternator 7 is charged to the rechargeable battery 4.

The load 8 includes, for example, at least one of an electronic control unit (ECU), a harness, a user interface, a light, a heater, a camera, an electric steering motor, a defogger, an ignition coil, a car audio device, and a car navigation device. The load 8 is powered by electricity supplied from the rechargeable battery 4. In the present embodiment, the load 8 includes an in-vehicle controller 8A and a wire harness 8B. The in-vehicle controller 8A is a kind of the electronic control unit.

As shown in FIG. 1, the battery state detection device 10 comprises a battery state detection unit 20 and a communication unit 30. The battery state detection unit 20 is configured to detect battery state information indicating a state of the rechargeable battery 4 installed to the vehicle 2. The battery state information includes, for example, at least one of a voltage, a current, a temperature, a charging rate (State of Charge (SOC)), and a deterioration state (State of Health (SOH)) of the rechargeable battery 4. The communication unit 30 is configured to transmit the battery state information to an external device 40. In the present embodiment, the communication unit 30 is separate from the battery state detection unit 20. The communication unit 30 is configured to be attached to the battery state detection unit 20. The communication unit 30 is configured to be detachably attached to the battery state detection unit 20. However, the battery state detection unit 20 and the communication unit 30 may be configured as a single unit. The communication unit 30 may be configured so that the communication unit 30 cannot be detached from the battery state detection unit 20 after being attached to the battery state detection unit 20.

The battery state detection unit 20 includes a sensor 22 and an estimator 23. In other words, the battery state detection device 10 comprises the sensor 22 and the estimator 23. The sensor 22 measures at least one of the voltage, the current, and the temperature of the rechargeable battery 4 installed to the vehicle 2. The estimator 23 is configured to estimate the state of the rechargeable battery 4 based on a measured value of the sensor 22. The sensor 22 includes a voltage sensor 22A, a current sensor 22B, and a temperature sensor 22C. In other words, the battery state detection unit 20 includes the voltage sensor 22A, the current sensor 22B, and the temperature sensor 22C.

The voltage sensor 22A is configured to measure the voltage of the rechargeable battery 4. The current sensor 22B is configured to measure the current of the rechargeable battery 4. The temperature sensor 22C is configured to measure the temperature of the rechargeable battery 4. The estimator 23 is configured to estimate the state of the rechargeable battery 4 based on at least one of a measured voltage of the voltage sensor 22A, a measured current of the current sensor 22B, and a measured temperature of the temperature sensor 22C.

The communication unit 30 includes a first connection part 31 and a communicator 32. In other words, the battery state detection device 10 comprises the communicator 32. The communicator 32 is electrically connected to the first connection part 31. The communicator 32 includes an information communicator 33 and a wireless communicator 34. In other words, the communication unit 30 comprises the first connection part 31, the information communicator 33, and the wireless communicator 34.

The first connection part 31 is configured to be detachably attached to the battery state detection unit 20. The first connection part 31 is electrically connected to the battery state detection unit 20 in a state where the first connection part is attached to the battery state detection unit 20. The information communicator 33 is configured to obtain the battery state information from the battery state detection unit 20 via the first connection part 31.

In the present embodiment, the first connection part 31 is configured to be detachably attached to the battery state detection unit 20. However, the first connection part 31 may be configured so that the first connection part 31 cannot be detached from the battery state detection unit 20 after being attached to the battery state detection unit 20. When the battery state detection unit 20 and the communication unit 30 are configured as a single unit, the first connection part 30 is omitted from the communication unit 30.

The wireless communicator 34 is configured to wirelessly transmit the battery state information obtained by the information communicator 33 to the external device 40. For example, the wireless communicator 34 is configured to perform wireless communication using at least one of the Bluetooth (registered trademark) standard and the Wi-Fi (registered trademark) standard. In the present embodiment, the wireless communicator 34 is configured to perform wireless communication using, for example, the Bluetooth standard and the Wi-Fi standard. However, the wireless communicator 34 may be configured to perform wireless communication using only one of the Bluetooth standard and the Wi-Fi standard. The wireless communicator 34 may be configured to perform wireless communication using communication standards other than the Bluetooth standard and the Wi-Fi standard. For example, the wireless communicator 34 may be configured to perform wireless communication using communication standards used in Intelligent Transport Systems (ITS). The ITS includes, for example, Vehicle Information and Communication System (VICS (registered trademark)), Electronic Toll Collection (ETC) systems, safe driving assistance systems, self-driving systems, and pedestrian support systems. The communication standards used in the ITS include, for example, LTE, WiMAX, LTE-Advanced, WiMAX2, HSPA+, and AXGP (TD-LTE) which are used in mobile communication systems (e.g., 3G, 4G, 5G, 6G, etc.). Thus, for example, the above communication standards can be used for communication between a vehicle equipped with the wireless communicator 34 and an object other than the vehicle. Communication between the vehicle and the object (Vehicle-to-Everything (V2X)) include, for example, Vehicle-to-Vehicle (V2V), Vehicle-to-Pedestrian (V2P), Vehicle-to-Network (V2N), and Vehicle-to-Infrastructure (V2I). However, the communication partners of the wireless communicator 34 are not limited to the examples of V2X. The wireless communicator 34 may be configured to perform wireless communication using communication standards other than the above communication standards.

The external device 40 includes at least one of a user terminal 41 and a server 42. In the present embodiment, the external device 40 includes the user terminal 41 and the server 42. Examples of the user terminals 41 include a smartphone and a tablet computer. The wireless communicator 34 is configured to communicate wirelessly with the user terminal 41 using, for example, the Bluetooth standard. The wireless communicator 34 is configured to communicate wirelessly with the server 42 via the Internet using the Wi-Fi standard. However, the wireless communicator 34 may be configured to perform wireless communication with the user terminal 41 using a communication standard other than the Bluetooth standard. The wireless communicator 34 may be configured to perform wireless communication with the server 42 using a communication standard other than the Wi-Fi standard. For example, the wireless communicator 34 may be configured to perform wireless communication using the communication standard used in the ITS as described above. The external device 40 may include only one of the user terminal 41 and the server 42 or may include devices other than the user terminal 41 and the server 42.

The information communicator 33 of the communication unit 30 is configured to obtain at least one of the measured voltage, the measured current, the measured temperature, and the estimation result of the estimator 23 via the first connection part 31 as the battery state information. In the present embodiment, the information communicator 33 is configured to acquire the measured voltage, the measured current, the measured temperature, and the estimation result of the estimator 23 via the first connection part 31 as battery state information. However, the battery state information obtained by the information communicator 33 is not limited to the measured voltage, the measured current, the measured temperature, and the estimation result of the estimator 23. The information communicator 33 can be configured to obtain at least one of the measured voltage, the measured current, the measured temperature, and the estimation result of the estimator 23 as the battery state information via the first connection part 31.

The information processing system 50 comprises the battery state detection device 10, the user terminal 41, and the server 42. In other words, the information processing system 50 comprises the communication unit 30, the user terminal 41, and the server 42. The information processing system 50 is configured to collect the battery state information and to update information (reference information described below) used for battery state detection.

The user terminal 41 is configured to communicate wirelessly with the communicator 32 of the battery state detection device 10. The user terminal 41 is configured to communicate wirelessly with the wireless communicator 34 of the communication unit 30. The server 42 is configured to be connected to the battery state detection device 10 and the user terminal 41 via the Internet. The server 42 is configured to be connected to the communication unit 30 and the user terminal 41 via the Internet.

The battery state detection device 10 is configured to transmit the battery state information to the user terminal 41 and the server 42 via the Internet. The user terminal 41 is configured to transmit the battery state information to the server 42 via the Internet. The battery state detection device 10 is configured to receive the update information from the server 42 via the Internet. The user terminal 41 is configured to receive the update information from the server 42 via the Internet.

The battery state detection unit 20 includes a discharge circuit 24. The discharge circuit 24 is configured to discharge the rechargeable battery 4. For example, the discharge circuit 24 is configured to perform pulse discharge of the rechargeable battery 4. The discharge circuit 24 includes, for example, a semiconductor switch and a resistor element which are connected in series. The estimator 23 is configured to control ON/OFF of the semiconductor switch of the discharge circuit 24. The discharge circuit 24 intermittently discharges the rechargeable battery 4 by controlling the ON/OFF of the semiconductor switch by the estimator 23. The estimator 23 is configured to obtain a component constituting an equivalent circuit of the rechargeable battery 4 based on a response when a pulsed current flows through the discharge circuit 24. The estimator 23 is configured to estimate the state of the rechargeable battery 4 based on the component constituting the equivalent circuit.

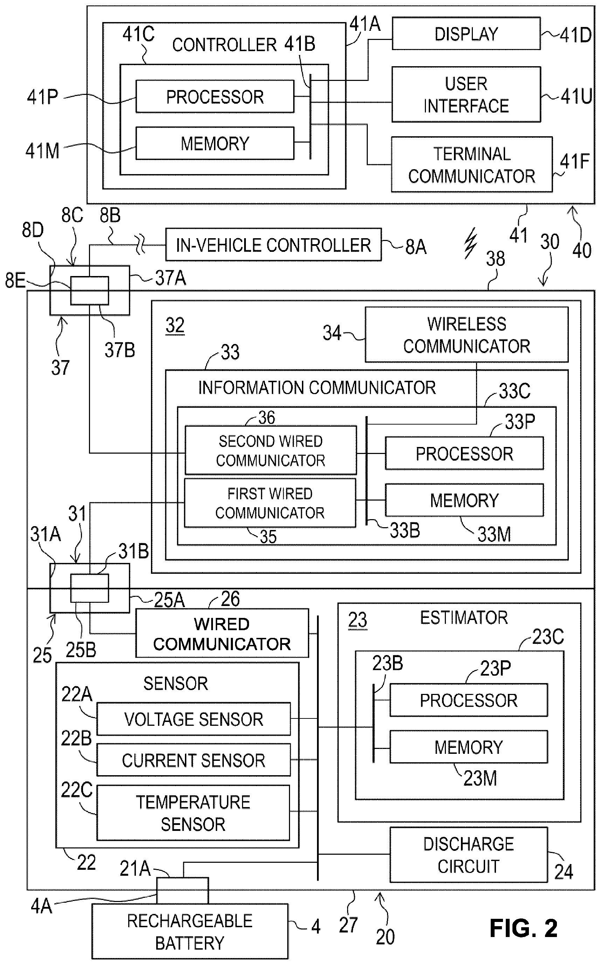

As shown in FIG. 2, the estimator 23 includes, for example, a processor 23P, a memory 23M, a circuit board 23C, and a bus 23B. The processor 23P includes, for example, a CPU (Central Processing Unit) and/or MPU (Micro Processing Unit). The memory 23M includes, for example, a volatile and/or non-volatile memory. Examples of the volatile memory include a RAM (Random Access Memory). Examples of the non-volatile memory include a ROM (Read Only Memory), an EEPROM (Electrically Erasable Programmable ROM), and a flash memory. The processor 23P is coupled to the memory 23M. The memory 23M is coupled to the processor 23P. The processor 23P and the memory 23M are electrically mounted on the circuit board 23C. The processor 23P and the memory 23M are electrically connected to each other via the circuit board 23C and the bus 23B. Each of the sensors 22 and the discharge circuit 24 is electrically connected to the processor 23P and the memory 23M via the circuit board 23C and the bus 23B. The memory 23M is configured to store programs. When the programs are read and executed by the processor 23P, the algorithms of the estimator 23 are realized. However, the structure of the estimator 23 is not limited to the structure described above. The algorithms of the estimator 23 may be realized by hardware only or by a combination of software and hardware. The estimator 23 can also be referred to as an estimator circuit 23 or estimator circuitry 23. The processor 23P can also be referred to as a hardware processor 23P. The memory 23M can also be referred to as a hardware memory 23M. At least one of the processor 23P and the memory 23M includes a semiconductor. That is, the estimator 23 includes a semiconductor.

The information communicator 33 includes, for example, a processor 33P, a memory 33M, a circuit board 33C, and a bus 33B. The processor 33P includes, for example, a CPU and/or MPU. The memory 33M includes, for example, a volatile and/or non-volatile memory. Examples of the volatile memory include a RAM. Examples of the non-volatile memory include a ROM, an EEPROM, and a flash memory. The processor 33P is coupled to the memory 33M. The memory 33M is coupled to the processor 33P. The processor 33P and the memory 33M are electrically mounted on the circuit board 33C. The processor 33P and the memory 33M are electrically connected to each other via the circuit board 33C and the bus 33B. Each of the first connection part 31 and the wireless communicator 34 is electrically connected to the processor 33P and the memory 33M via the circuit board 33C and the bus 33B. The memory 33M is configured to store programs. When the programs are read and executed by the processor 33P, the algorithms of the information communicator 33 are realized. However, the structure of the information communicator 33 is not limited to the structure described above. The algorithms of the information communicator 33 may be realized by hardware only or by a combination of software and hardware. The information communicator 33 can also be referred to as an information communicator circuit 33 or information communicator circuitry 33. The processor 33P can also be referred to as a hardware processor 33P. The memory 33M can also be referred to as a hardware memory 33M. At least one of the processor 33P and the memory 33M includes a semiconductor. That is, the information communicator 33 includes a semiconductor.

The wireless communicator 34 includes communication circuitry configured to transmit and receive information using wireless communication protocols. For example, the wireless communicator 34 includes an antenna, a wireless signal transmitter circuit, and a wireless signal receiver circuit. In other words, the wireless communicator 34 can also be referred to as a wireless communicator circuit 34 or wireless communicator circuitry 34.

The information communicator 33 includes a first wired communicator 35. The first wired communicator 35 is configured to receive the battery state information from the battery state detection unit 20 via the first connection part 31 by wired communication. The first wired communicator 35 is configured to receive, as the battery state information, at least one of the measured voltage, the measured current, the measured temperature, and the estimation result of the estimator 23 from the battery state detection unit 20 via the first connection part 31 by wired communication. In the present embodiment, the first wired communicator 35 is configured to receive, as the battery state information, the measured voltage, the measured current, the measured temperature, and the estimation result of the estimator 23 from the battery state detection unit 20 via the first connection part 31. However, the battery state information obtained by the first wired communicator 35 is not limited to the measured voltage, the measured current, the measured temperature, and the estimation result of the estimator 23. The first wired communicator 35 can be configured to obtain, as the battery state information, at least one of the measured voltage, the measured current, the measured temperature, and the estimation result of the estimator 23 via the first connection part 31.

The information communicator 33 includes a second wired communicator 36. The second wired communicator 36 is configured to wirelessly transmit the battery state information to the in-vehicle controller 8A of the vehicle 2. The communication unit 30 further comprises a second connection part 37 electrically connectable to the in-vehicle controller 8A. The second wired communicator 36 is configured to transmit the battery state information to the in-vehicle controller 8A via the second connection part 37 by wired communication.

The second wired communicator 36 is configured to transmit, as the battery state information, at least one of the measured voltage, the measured current, the measured temperature, and the estimation result of the estimator 23 to the in-vehicle controller 8A of the vehicle 2 via the second connection part 37 by wired communication. In the present embodiment, the second wired communicator 36 is configured to transmit, as the battery state information, the measured voltage, the measured current, the measured temperature, and the estimation result of the estimator 23 to the in-vehicle controller 8A of the vehicle 2 via the second connection part 37 by wired communication. However, the battery state information transmitted by the second wired communicator 36 can include at least one of the measured current, the measured temperature, and the estimation result of the estimator 23. The second wired communicator 36 can be configured to transmit, as the battery state information, at least one of the measured voltage, the measured current, the measured temperature, and the estimation result of the estimator 23 to the in-vehicle controller 8A of the vehicle 2 via the second connection part 37 by wired communication.

The load 8 includes a system connection part 8C. The second connection part 37 is configured to be detachably connected to the system connection part 8C. The second connection part 37 is electrically connectable to the system connection part 8C. The system connection part 8C is provided at the end of the wire harness 8B.

As shown in FIG. 2, the first wired communicator 35 is configured to receive the battery state information from the battery state detection unit 20 via the first connection part 31 by wired communication using a first protocol. The second wired communicator 36 is configured to transmit the battery state information to the in-vehicle controller 8A by wired communication using a second protocol different from the first protocol. The first wired communicator 35 includes communication circuitry configured to transmit and receive information by wired communication using the first protocol. The second wired communicator 36 includes communication circuitry configured to transmit and receive information by wired communication using the second protocol. In other words, the first wired communicator 35 can also be referred to as a first wired communicator circuit 35 or first wired communicator circuitry 35. The second wired communicator 36 can also be referred to as a second wired communicator circuit 36 or second wired communicator circuitry 36.

In the present embodiment, the first protocol includes Local Interconnect Network (LIN). The second protocol includes Controller Area Network (CAN). However, the first protocol can include protocols other than LIN. The second protocol can include protocols other than CAN.

The battery state detection unit 20 includes a detection-unit connection part 25. The first connection part 31 is configured to be detachably connected to the detection-unit connection part 25 of the battery state detection unit 20. The first connection part 31 is electrically connectable to the detection-unit connection part 25.

The battery state detection unit 20 includes a third wired communicator 26. The third wired communicator 26 is electrically connected to the detection-unit connection part 25 and the estimator 23. The third wired communicator 26 is configured to transmit the battery state information to the communication unit 30 by wired communication via the detection-unit connection part 25. The third wired communicator 26 is configured to transmit the battery state information to the communication unit 30 via the detection-unit connection part 25 by wired communication using the first protocol. The third wired communicator 26 includes communication circuitry configured to transmit and receive information by wired communication using the first protocol. In other words, the third wired communicator 26 can also be referred to as a third wired communicator circuit 26 or third wired communicator circuitry 26.

The battery state detection unit 20 includes a battery connection part 21A. The battery connection part 21A is attachable to the terminal 4A of the rechargeable battery 4. The battery connection part 21A is configured to be detachably connected to the terminal 4A of the rechargeable battery 4. The battery connection part 21A is electrically connected to the sensor 22, the estimator 23, the discharge circuit 24, and the third wired communicator 26.

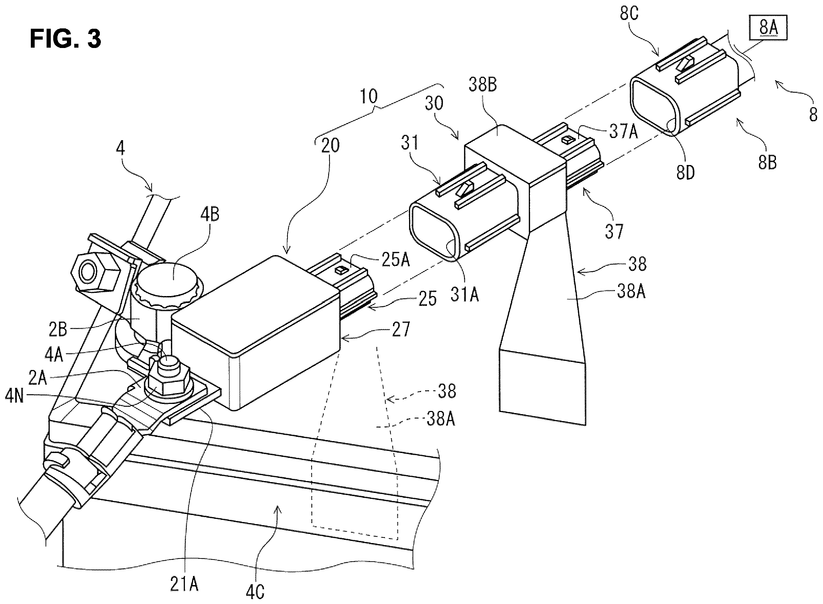

As shown in FIG. 3, a harness 2A of the vehicle 2 is connected to the terminal 4A of the rechargeable battery 4. The terminal 4A of the rechargeable battery 4 includes a stud bolt of the rechargeable battery 4. The battery connection part 21A and the harness 2A are connected to the terminal 4A of the rechargeable battery 4 with a nut 4N. Electricity is supplied from the rechargeable battery 4 to the load 8 of the vehicle 2 via the harness 2A.

The battery state detection unit 20 is configured to be mounted on a battery post 4B. The battery state detection unit 20 includes a battery post terminal 2B. The battery post terminal 2B is configured to be detachably connected to the battery post 4B.

A shape of the first connection part 31 is complementary to a shape of the detection-unit connection part 25. For example, the first connection part 31 includes a first connection hole 31A and a first connection terminal 31B (see FIG. 2). The first connection terminal 31B is provided in the first connection hole 31A. The detection-unit connection part 25 includes a connection protrusion 25A and a detection unit terminal 25B (see FIG. 2). The detection unit terminal 25B is provided in the connection protrusion 25A. The battery state detection unit 20 includes a unit housing 27. The connection protrusion 25A protrudes from the unit housing 27. The connection protrusion 25A of the detection-unit connection part 25 can be inserted into the first connection hole 31A of the first connection part 31. In a state where the connection protrusion 25A is positioned in the first connection hole 31A, the detection unit terminal 25B is in contact with the first connection terminal 31B. Thus, the first connection part 31 is electrically connectable with the detection-unit connection part 25 of the battery state detection unit 20.

The battery state detection unit 20 may include a connection hole, and the first connection part 31 may include a protrusion which can be inserted into the connection hole. The shapes of the first connection part 31 and the detection-unit connection part 25 may be other than a protrusion and a hole. The shape of the first connection part 31 does not need to be complementary to the shape of the detection-unit connection part 25.

A shape of the second connection part 37 is complementary to a shape of the system connection part 8C of the load 8. For example, the system connection part 8C includes a system connection hole 8D and a system connection terminal 8E (see FIG. 2). The system connection terminal 8E is provided in the system connection hole 8D. The second connection part 37 includes a second connection protrusion 37A and a second connection terminal 37B (see FIG. 2). The second connection terminal 37B is provided in the second connection protrusion 37A. The communication unit 30 further comprises a housing 38 which houses the information communicator 33. The second connection protrusion 37A protrudes from the housing 38. The second connection protrusion 37A can be inserted into the system connection hole 8D of the system connection part 8C. In a state where the second connection protrusion 37A is positioned in the system connection hole 8D, the second connection terminal 37B is in contact with the system connection terminal 8E. Thus, the system connection part 8C is electrically connectable to the second connection part 37.

The second connection part 37 may include a connection hole, and the system connection part 8C may include a protrusion which can be inserted into the connection hole. The shapes of the second connection part 37 and the system connection part 8C may be other than a protrusion and a hole. The shape of the second connection part 37 does not need to be complementary to the shape of the system connection part 8C.

In the present embodiment, a shape of the second connection part 37 is complementary to a shape of the first connection part 31. Thus, a shape of the detection-unit connection part 25 is complementary to a shape of the system connection part 8C. The communication unit 30 can be detached from the detection-unit connection part 25 and the system connection part 8C, and the system connection part 8C can be connected to the detection-unit connection part 25. Specifically, the connection protrusion 25A of the detection-unit connection part 25 can be inserted into the system connection hole 8D of the system connection part 8C. In a state where the connection protrusion 25A is positioned in the system connection hole 8D, the detection unit terminal 24B is in contact with the system connection terminal 8E. Therefore, the detection-unit connection part 25 of the battery state detection unit 20 can be electrically connected to the system connection part 8C. However, the shape of the second connection part 37 does not need to be complementary to the shape of the first connection part 31. The shape of detection-unit connection part 25 does not need to be complementary to the shape of system connection part 8C.

The housing 38 includes a rotation stopper 38A contactable with the side 4C of the rechargeable battery 4. The housing 38 includes a housing body 38B. The rotation stopper 38A protrudes from the housing body 38B. In a state where the battery state detection unit 20 is attached to the rechargeable battery 4 and where the communication unit 30 is attached to the battery state detection unit 20, the rotation stopper 38A is in contact with the side 4C of the rechargeable battery 4. Therefore, the rotation stopper 38A can limit the rotation of the battery state detection unit 20 and the communication unit 30 with respect to the rechargeable battery 4. The rotation stopper 38A may be omitted from the housing 38. The rotation stopper 38A may be provided to the battery state detection unit 20.

As shown in FIGS. 2 and 3, the communicator 32 is provided separately from at least one of the sensor 22 and the estimator 23. The communicator 32 is configured to be detachably attached to at least one of the sensor 22 and the estimator 23.

In the present embodiment, the communicator 32 is provided separately from the sensor 22 and the estimator 23. The communicator 32 is configured to be detachably attached to the sensor 22 and the estimator 23. The housing 38 of the communication unit 30 is configured to be detachably attached to the unit housing 27 of the battery state detection unit 20. Specifically, the first connection part 31 of the communication unit 30 is configured to be detachably attached to the detection-unit connection part 25 of the battery state detection unit 20. However, the communication unit 30 may be configured as a single unit with the battery state detection unit 20. The communicator 32 may be configured as a single unit with the sensor 22 and the estimator 23. In a case where the sensor 22 is separate from the estimator 23, the communicator 32 may be provided separately from one of the sensor 22 and the estimator 23, or the communicator 32 may be configured as a single unit with the other of the sensor 22 and the estimator 23.

As shown in FIG. 2, the communicator 32 is configured to obtain reference information relating to the battery state detection from the external device 40. The wireless communicator 34 is configured to wirelessly receive the reference information relating to the battery state detection from the external device 40. The information communicator 33 transmits the reference information received by the wireless communicator 34 to at least one of the in-vehicle controller 8A and the battery state detection unit 20. In the present embodiment, the communicator 32 is configured to obtain the reference information from the user terminal 41. The wireless communicator 34 is configured to wirelessly receive the reference information relating to the battery state detection from the user terminal 41. The information communicator 33 transmits the reference information received by the wireless communicator 34 to the in-vehicle controller 8A and the battery state detection unit 20.

The reference information includes at least one of battery identification information enabling the rechargeable battery to be identified, electrical component information relating to an electrical component which has been custom-installed to the vehicle, user usage information relating to at least one of vehicle usage frequency and a vehicle usage method of the user, and history information relating to at least one of replacement history and reconnection history of the rechargeable battery. In the present embodiment, the reference information includes the battery identification information, the electrical component information, the user usage information, and the history information. The reference information also includes vehicle identification information relating to a model and a grade of the vehicle. However, the reference information is not limited to the above information.

The battery identification information includes at least one of a standard (e.g., JIS), a size, a manufacturer, and a type of the rechargeable battery 4. Types of the rechargeable battery 4 include a liquid battery, an enhanced flooded battery (EFB: Enhanced Flooded Battery), and a dry battery (e.g., Absorbed Glass Mat (AGM) battery). The electrical component information includes electrical components such as a monitor, an Electric Toll Collection (ETC) unit, and a drive recorder.

The vehicle usage frequency of the user includes the frequency of use of the vehicle 2 in a week (frequency of starting the engine 5) and the usage time of the vehicle 2 per day. The vehicle usage method of the user includes, for example, commuting, work, and general household use. The replacement history of the rechargeable battery 4 indicates whether the rechargeable battery 4 has been replaced with a new battery. The reconnection history of the rechargeable battery 4 indicates whether the rechargeable battery 4 has been temporarily disconnected and then reconnected.

The user terminal 41 is configured to receive an input of the reference information relating to the battery state detection. Specifically, the user terminal 41 includes a controller 41A, a display 41D, a user interface 41U, a terminal communicator 41F, and a case 41E. The case 41E houses the controller 41A and the terminal communicator 41F. The controller 41A is electrically connected to the display 41D, the user interface 41U, and the terminal communicator 41F and is configured to control the display 41D, the user interface 41U, and the terminal communicator 41F.

The controller 41A includes, for example, a processor 41P, a memory 41M, a circuit board 41C, and a bus 41B. The processor 41P includes, for example, a CPU and/or MPU. The memory 41M includes, for example, a volatile and/or non-volatile memory. Examples of the volatile memory include a RAM. Examples of the non-volatile memory include a ROM, an EEPROM, and a flash memory. The processor 41P is coupled to the memory 41M. The memory 41M is coupled to the processor 41P. The processor 41P and the memory 41M are electrically mounted on the circuit board 41C. The processor 41P and the memory 41M are electrically connected to each other via the circuit board 41C and the bus 41B. Each of the sensor 22 and the discharge circuit 24 is electrically connected to the processor 41P and the memory 41M via the circuit board 41C and the bus 41B. The memory 41M is configured to store programs. When the programs are read and executed by the processor 41P, the algorithms of the controller 41A are realized. However, the structure of the controller 41A is not limited to the structure described above. The algorithms of the controller 41A may be realized by hardware only or by a combination of software and hardware. The controller 41A can also be referred to as an electronic controller 41A, an electronic controller circuit 41A, or electronic controller circuitry 41A. The processor 41P can also be referred to as a hardware processor 41P. The memory 41M can also be referred to as a hardware memory 41M. At least one of the processor 41P and the memory 41M includes a semiconductor. That is, the controller 41A includes a semiconductor.

The display 41D is configured to display information for inputting the reference information. The user interface 41U is configured to receive the input of the reference information. The user interface 41U includes at least one of a plurality of buttons and a touch panel. In the case of the touch panel, the user interface 41U is provided on the display 41D. The controller 41A is configured to store the reference information which is input via the user interface 41U.

The terminal communicator 41F is configured to transmit and receive information wirelessly. The terminal communicator 41F includes communication circuitry configured to transmit and receive information wirelessly. For example, the terminal communicator 41F includes an antenna, a wireless signal transmitter circuit, and a wireless signal receiver circuit. In other words, the terminal communicator 41F can also be referred to as a terminal communicator circuit 41F or terminal communicator circuitry 41F. The terminal communicator 41F is configured to wirelessly transmit the reference information input via the user interface 41U to the communication unit 30. The wireless communicator 34 of the communication unit 30 is configured to wirelessly receive the reference information from the terminal communicator 41F of the user terminal 41. The information communicator 33 of the communication unit 30 stores the reference information received via the wireless communicator 34 in the memory 33M. The structure of the user terminal 41 is not limited to the structure described above. The user terminal 41 may have other structures.

The user can input the reference information (the battery identification information, the electrical component information, the user usage information, and the history information) via the user interface 41U while viewing the information displayed on the display 41D of the user terminal 41. The input reference information is wirelessly transmitted from the user terminal 41 to the communication unit 30 and is transmitted from the communication unit 30 to the battery state detection unit 20. The estimator 23 stores the received reference information in the memory 23M.

For example, the user can select, via the user interface 41U, a manufacturer, a model number, and a size of the rechargeable battery 4 installed to the vehicle 2 from a plurality of manufacturers, a plurality of model numbers, and a plurality of sizes displayed on the display 41D. The user can select, via the user interface 41U, an electrical component which has been custom-installed to the vehicle 2 from a plurality of electrical components displayed on the display 41D. The user can select, via the user interface 41U, the actual usage frequency and the actual usage time of the vehicle 2 from a plurality of usage frequencies and a plurality of usage times displayed on the display 41D. The user can input answers, via the user interface 41U, to questions "Did you replace the battery with a new one?" and "Did you reconnect the battery?" which are displayed on the display 41D. These answers are included in the reference information.

The battery state detection unit 20 detects the state (SOC and SOH) of the rechargeable battery 4 based on the reference information received from the user terminal 41 via the communication unit 30. The estimator 23 is configured to correct estimation process information relating to the estimation of the state of the rechargeable battery 4 based on the reference information. The estimation process information includes, for example, at least one of an estimation equation and a parameter. That is, the estimator 23 is configured to correct at least one of the estimation equation and the parameter based on the reference information.

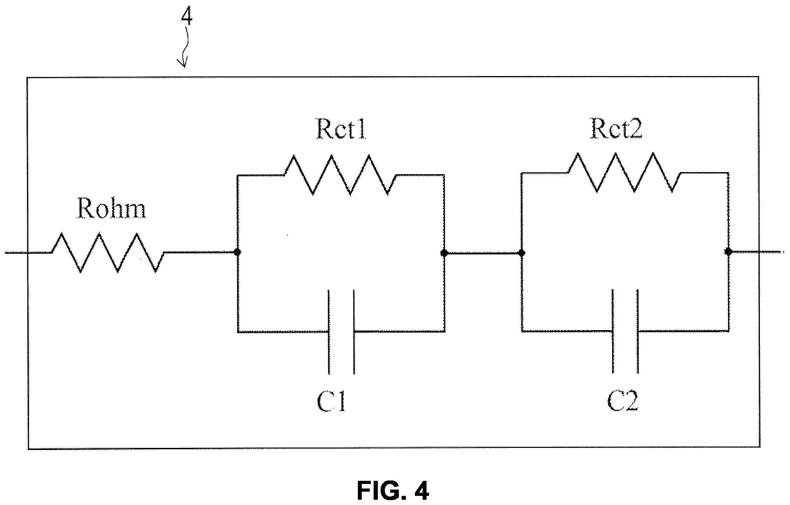

As shown in FIG. 4, an electrical equivalent circuit of the rechargeable battery 4 has, as components (elements), for example, conductive resistance Rohm, reaction resistances Rct1 and Rct2, and electric double-layer capacitances C1 and C2. The conductive resistance Rohm is a resistive component corresponding to conductive elements and electrolyte resistance inside the rechargeable battery 4. The reaction resistance Rct1 and Rct2 are resistance components corresponding to the reaction resistance of active material reaction of electrodes. The electric double-layer capacitances C1 and C2 are capacity components corresponding to the electric double layers between the electrode and the electrolyte interface.

The estimator 23 is configured to optimize the element values of the elements constituting the equivalent circuit. The estimator 23 is configured to optimize the element values of the elements constituting the equivalent circuit through a learning process. As a method for optimizing the element values, for example, as described in JP Patent No. 4,532,416, it is possible to use a method in which an optimal state vector is estimated by an extended Kalman filter operation and then the adjustment parameters of the equivalent circuit are updated to the optimal ones from the estimated state vector.

Specifically, in a state where the charging and discharging of the rechargeable battery 4 are suspended, the estimator 23 calculates the voltage drop value when the rechargeable battery 4 is discharged with a given current pattern based on the equivalent circuit which uses the adjustment parameters obtained from the state vector in a certain state. For example, the estimator 23 controls the discharge circuit 24 to perform the pulse discharge of the rechargeable battery 4. The estimator 23 controls the discharge circuit 24 to perform the pulse discharge of the rechargeable battery 4 to achieve the predetermined current pattern.

One method of determining whether the rechargeable battery 4 is in the state where the charging and discharging are suspended is, for example, to use the absolute value of the measured current |Im|. That is, in a case where the absolute value of the measured current |Im| is greater than a predetermined threshold value Ith, the estimator 23 concludes that the charging and discharging are in progress (startup, running state). In a case where the absolute value |Im| is less than the predetermined threshold value Ith, the estimator 23 concludes that the rechargeable battery 4 is in the state where the charging and discharging are suspended (a state where the charging and discharging are not practically executed and where only dark current is flowing).

The estimator 23 updates the state vector so that the voltage drop value approaches the measured value. The estimator 23 calculates the optimal adjustment parameters from the updated state vector and calculates the element values of the elements constituting the equivalent circuit based on the constants and the optimized adjustment parameters. The method of optimizing the element values of the elements constituting the equivalent circuit may be other methods such as a least squares calculation or appropriately educated neural networks.

The SOH of the rechargeable battery 4 can be estimated by substituting the element values of the conductive resistance Rohm, the reactive resistance Rct1 and Rct2, and the electric double-layer capacitances C1 and C2 into the following first estimation equation (1).

$$\mathrm{SOH} = f\,(\mathrm{Rohm},\ \mathrm{Rct1},\ \mathrm{Rct2},\ \mathrm{C1},\ \mathrm{C2}) \qquad (1)$$

However, the constants used for optimization depend on the size of the rechargeable battery 4. Therefore, the estimator 23 is configured to correct the component constituting the equivalent circuit based on the reference information. Specifically, the estimator 23 is configured to correct the component constituting the equivalent circuit based on the battery identification information. The estimator 23 obtains constants for optimizing the element values of the elements constituting the equivalent circuit based on the size included in the battery identification information.

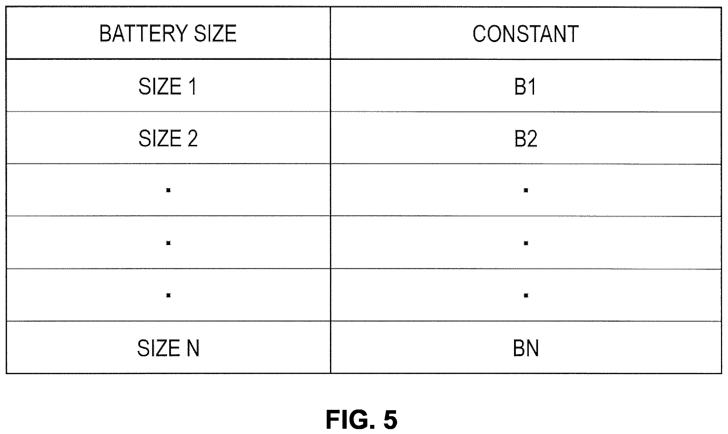

For example, as shown in FIG. 5, the estimator 23 stores a plurality of constants corresponding to a plurality of sizes in the memory 23M. As mentioned above, the size of the rechargeable battery 4 installed to the vehicle 2 (i.e., to which the battery state detection unit 20 is connected) is input to the user terminal 41 and is transmitted to the battery state detection unit 20 via the communication unit 30. The estimator 23 stores the received size in the memory 23M. The estimator 23 selects a constant corresponding to the size input to the user terminal 41 from the plurality of constants stored in the memory 23M. Based on the selected constant, the estimator 23 calculates the element values of the components constituting the equivalent circuit using the method described above. In other words, the estimator 23 corrects the component constituting the equivalent circuit based on the selected constant. This enables the SOH of the rechargeable battery 4 to be more accurately estimated.

The estimator 23 is configured to select, based on the user usage information, a correction coefficient for correcting the component constituting the equivalent circuit. The estimator 23 is configured to select the correction coefficient for correcting the component constituting the equivalent circuit based on the user usage information received from the user terminal 41 via the communication unit 30.

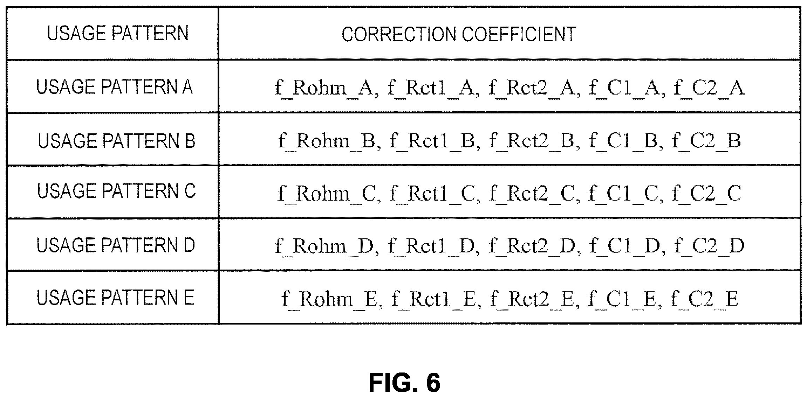

The user terminal 41 is configured to receive the input of the user usage information. The user usage information includes, for example, the frequency with which the engine 5 of the vehicle 2 is started (e.g., once a week, twice a week, five times a week, daily, etc.) and the average usage time of the engine 5 per day. Based on the input user usage information, the usage patterns of the vehicle 2 can be classified into usage patterns A to E, for example, shown in FIG. 6. Each of the usage patterns A to E has a threshold for the start frequency and the average usage time of the engine 5. By comparing the start frequency and the average usage time of the engine 5 with the thresholds of the usage patterns A to E, one of the usage patterns A to E can be selected as the usage pattern of the vehicle 2. The usage pattern A corresponds to the case where the rechargeable battery 4 is replaced with a new one, as described below. Therefore, the case where the start frequency and the average usage time of the engine 5 are zero corresponds to the usage pattern A. The usage patterns may be classified depending on criteria other than the above or may be classified into more or less usage patterns than the usage patterns A to E.

The estimator 23 obtains the correction coefficient corresponding to the aforementioned first estimation equation (1) for each usage pattern. The estimator 23 stores, in the memory 23M, a plurality of correction coefficients corresponding to the plurality of usage patterns, respectively. As shown in FIG. 6, the estimator 23 stores the correction coefficients f_Rohm_A, f_Rct1_A, f_Rct2_A, f_Rct1_A, f_C1_A, and f_C2_A which correspond to the usage pattern A in the memory 23M. Since the usage pattern A corresponds to the case where the rechargeable battery 4 is replaced with a new one, the correction coefficients f_Rohm_A, f_Rct1_A, f_Rct2_A, f_Rct1_A, f_C1_A, and f_C2_A are 1. The estimator 23 stores the correction coefficients f_Rctm_B, f_Rct1_B, f_Rct2_B, f_Rct1_B, f_C1_B, and f_C2_B which correspond to the usage pattern B in the memory 23M. The estimator 23 stores the correction coefficients f_Rohm_C, f_Rct1_C, f_Rct2_C, f_Rct1_C, f_C1_C, and f_C2_C which correspond to the usage pattern C in the memory 23M. The estimator 23 stores the correction coefficients f_Rohm_D, f_Rct1_D, f_Rct2_D, f_Rct1_D, f_C1_D, and f_C2_D which correspond to the usage pattern D in the memory 23M. The estimator 23 stores the correction coefficients f_Rohm_E, f_Rct1_E, f_Rct2_E, f_Rct1_E, f_C1_E, and f_C2_E which correspond to the usage pattern E in the memory 23M.

The estimator 23 selects the correction coefficient corresponding to the usage pattern included in the user usage information received via the communication unit 30 from the plurality of correction coefficients stored in the memory 23M. For example, in a case where the usage pattern included in the user usage information is the usage pattern A, the estimator 23 selects the correction coefficients f_Rohm_A, f_Rct1_A, f_Rct2_A, f_Rct1_A, f_C1_A, and f_C2_A which correspond to the usage pattern A. The estimator 23 calculates the SOH from the equation (1) using the selected correction coefficient. This enables the SOH to be calculated depending on the usage pattern, making it possible to obtain a highly accurate SOH.

After selecting the correction coefficient, the estimator 23 calculates the element values of the equivalent circuit elements Rohm, Rct1, Rct2, C1, and C2 through the learning process and applies them to the first estimation equation (1) to calculate the SOH. The estimator 23 stores the SOH and the element values of the elements Rohm, Rct1, Rct2, C1, and C2 calculated through the learning process in the memory 23M.

Specifically, the estimator 23 stores the initial values Rohmi, Rctli, Rct2i, C1i, and C2i of the element values of the equivalent circuit in the memory 23M. The estimator 23 calculates the difference values $\Delta$Rohm, $\Delta$Rct1, $\Delta$Rct2, $\Delta$C1, and $\Delta$C2 between the element values calculated through the learning process and the initial values based on the following equations (3) to (7).

$$\Delta Rohm = Rohm - Rohmi \qquad (3)$$

$$\Delta Rct1 = Rct1 - Rct1i \qquad (4)$$

$$\Delta Rct2 = Rct2 - Rct2i \qquad (5)$$

$$\Delta C1 = C1 - C1i \qquad (6)$$

$$\Delta C2 = C2 - C2i \qquad (7)$$

In a case where the usage pattern A is selected, the estimator 23 calculates $\Delta\alpha\_Rohm$, $\Delta\alpha\_Rct1$, $\Delta\alpha\_Rct2$, $\Delta\alpha\_C1$, and $\Delta\alpha\_C2$ based on the following equations (8) to (12). In a case where one of the usage patterns B to E is selected, the second terms on the right side of the equations (8) to (12) are replaced with the correction coefficients corresponding to the selected usage pattern of the usage patterns B to E.

$$\Delta\alpha\_Rohm = \delta Rohm \times f\_Rohm\_A \qquad (8)$$

$$\Delta\alpha\_Rct1 = \Delta Rct1 \times f\_Rct1\_A \qquad (9)$$

$$\Delta\alpha\_Rct2 = \Delta Rct2 \times f\_Rct2\_A \qquad (10)$$

$$\Delta\alpha\_C1 = \Delta C1 - C1i \times f\_C1\_A \qquad (11)$$

$$\Delta\alpha\_C2 = \Delta C2 - C2i \times f\_C2\_A \qquad (12)$$

The estimator 23 calculates the SOH of the rechargeable battery 4 based on the following second estimation equation (13). Note that "f ( )" is a predetermined function with $\Delta\alpha\_Rohm$, $\Delta\alpha\_Rct1$, $\Delta\alpha\_Rct2$, $\Delta\alpha\_C1$, and $\Delta\alpha\_C2$ as variables.

$$SOH = f\,(\Delta\alpha\_Rohm,\ \Delta\alpha\_Rct1,\ \Delta\alpha\_Rct2,\ \Delta\alpha\_C1,\ \Delta\alpha\_C2) \qquad (13)$$

The estimator 23 is configured to correct, based on the history information, an estimation process or an estimation result which uses the component constituting the equivalent circuit. Specifically, in a case where the history information indicates that the rechargeable battery 4 has been replaced, the estimator 23 corrects each of the aforementioned correction coefficients to 1 by selecting the usage pattern A as the usage pattern. In other words, the estimator 23 corrects, based on the history information that the rechargeable battery 4 has been replaced, the estimation process which uses the component constituting the equivalent circuit.

In a case where the history information indicates that the rechargeable battery 4 has been temporarily disconnected and then reconnected, the estimator 23 requests the user to input the user usage information via the user terminal 41 and selects the usage pattern based on the user usage information which is newly input to the user terminal 41. The estimator 23 selects the correction coefficient based on the selected usage pattern and corrects the element values of the element constituting the equivalent circuit based on the selected correction coefficient. In other words, the estimator 23 corrects the estimation process which uses the component constituting the equivalent circuit based on the history information that the rechargeable battery 4 has been temporarily disconnected and then reconnected.

In a case where the vehicle 2 stops and the engine 5 stops, the electric steering motor, the defogger, the ignition coil, the car audio system, the car navigation system, and so on, which are included in the load 8, are stopped, and only the electrical component which has been custom-installed to the vehicle 2 (e.g., a clock, a car security system, and the battery state detection unit 20) operates. Therefore, a weak current called a dark current (several mA to several hundred mA) flows from the rechargeable battery 4 to the load 8. Although the dark current is weak, the dark current affects the measurement of an open circuit voltage (OCV) of the rechargeable battery 4.

On the other hand, standard values of the dark current for the vehicle 2 before custom-installing the electrical component can also be set in advance based on the vehicle identification information such as the model and the grade of the vehicle 2. The standard values of the dark current caused by the custom-installed electrical component can also be set in advance for each electrical component. Therefore, the estimator 23 is configured to correct the estimation process information relating to the estimation of the state of the rechargeable battery 4 based on the electrical component information. Specifically, the estimator 23 is configured to correct at least one of the estimation equation and a parameter based on the electrical component information.

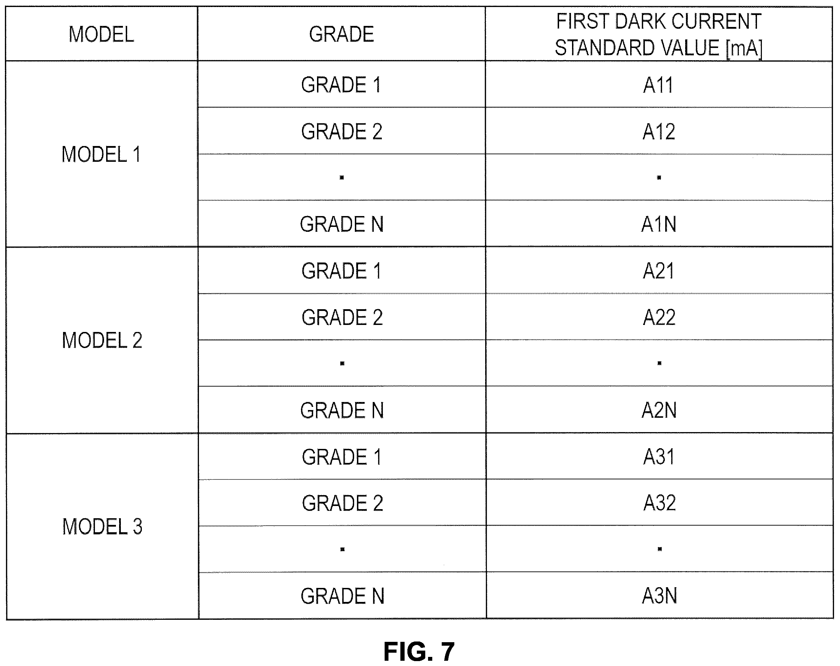

As shown in FIG. 7, the estimator 23 stores a plurality of first dark current standard values corresponding to a plurality of models and grades in the memory 23M in advance. The estimator 23 obtains the model and the grade of the vehicle from the vehicle identification information received from the user terminal 41 via the communication unit 30 and stores them in the memory 23M. The estimator 23 selects a dark current standard value corresponding to the model and the grade included in the vehicle identification information from the plurality of first dark current standard values stored in the memory 23M.

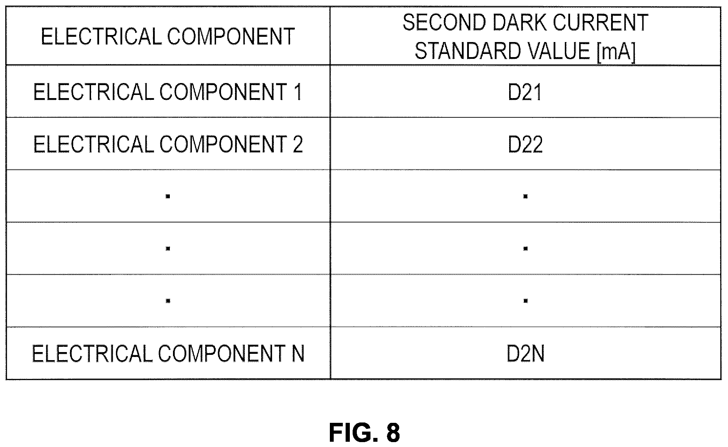

As shown in FIG. 8, the estimator 23 stores a plurality of second dark current standard values corresponding to a plurality of assumed electrical components in the memory 23M in advance. The estimator 23 stores in the memory 23M the custom-installed electrical components included in the electrical component information received from the user terminal 41 via the communication unit 30. The estimator 23 selects a dark current standard value corresponding to each electrical component included in the electrical component information from the plurality of second dark current standard values stored in the memory 23M. The estimator 23 calculates the sum of the selected first dark current standard value and the selected second dark current standard value and stores it in the memory 23M as a total dark current value.

The estimator 23 stores a third estimation equation for estimating the voltage drop value from the dark current value in the memory 23M in advance. The estimator 23 calculates the voltage drop value by inputting the total dark current value into the third estimation equation. The estimator 23 calculates the OCV by adding the voltage drop value to the measured voltage. The estimator 23 stores the fourth estimation equation, which is a relational expression between the OCV and the SOC, in the memory 23M. The estimator 23 calculates the SOC based on the OCV and the fourth estimation equation. This enables the SOC to be accurately estimated by taking into account the dark current.

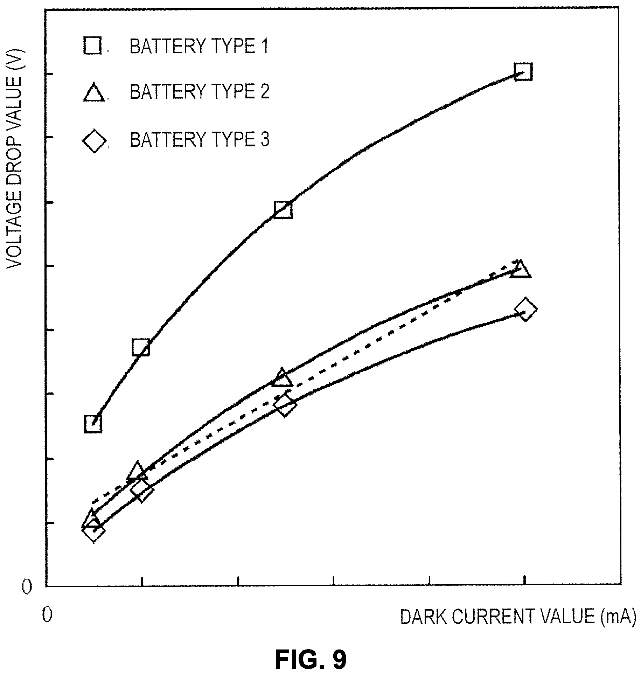

However, it is conceivable that the third estimation equation indicating the relationship between the dark current value and the voltage drop value may change depending on the type of the rechargeable battery 4. FIG. 9 shows, for example, the relationships between the voltage drop values ΔV and values of the dark current flowing in three different types of rechargeable batteries 4 which are measured in a state where the temperature of the rechargeable battery 4 is 25°C and the SOC is 100%, and the comparison between the respective results. In FIG. 9, squares, triangles, and diamonds indicate the actual measurement results for the three battery types, and the solid lines indicate the estimated results for each battery type using the aforementioned equation (1). As can be seen from FIG. 9, the relationship between the dark current value and the voltage drop value varies depending on the battery type (e.g., standard, capacity, size, manufacturer, charged state, etc.). Therefore, the estimator 23 stores the plurality of third estimation equations corresponding to the plurality of battery types in the memory 23M in advance. The estimator 23 selects, from the plurality of third estimation equations stored in the memory 23M, an estimation equation corresponding to the battery type included in the battery identification information received via the communication unit 30. The estimator 23 calculates the voltage drop value corresponding to the dark current value based on the selected third estimation equation. By inputting the total dark current value into the selected third estimation equation, the estimator 23 can calculate a more accurate voltage drop value. Thus, the SOC can be estimated more accurately by taking into account the dark current and the battery type.

The battery state information obtained by the battery state detection unit 20 is uploaded to the server 42 and is used to improve the accuracy of the estimation of the battery state detection.

Specifically, the battery state detection unit 20 transmits, to the communication unit 30, the battery state information (e.g., SOC, SOH) obtained from the rechargeable battery 4. The information communicator 33 of the communication unit 30 obtains the battery state information from the battery state detection unit 20. The wireless communicator 34 is configured to upload the battery state information obtained by the information communicator 33 to the server 42. The wireless communicator 34 is configured to upload the battery state information obtained by the information communicator 33 to the server 42 via the Internet. The wireless communicator 34 is configured to wirelessly transmit the battery state information obtained by the information communicator 33 to the user terminal 41. The user terminal 41 uploads the battery state information to the server 42 via the Internet.

The user terminal 41 is configured to inquire of the user of the user terminal 41 whether or not to permit the uploading of the battery state information. The controller 41A displays, on the display 41D, the inquiry relating to whether or not to permit the uploading of the battery state information. In a case where the user permits the uploading, the terminal communicator 41F transmits the battery state information to the server 42 via the Internet.

The server 42 is configured to analyze the uploaded battery state information. The server 42 can generate update information for improving the accuracy of the battery state information by collecting and analyzing various battery state information. The server 42 transmits the update information to the user terminal 41. The user terminal 41 transmits the update information to the battery state detection unit 20 via the communication unit 30. The estimator 23 of the battery state detection unit 20 updates the reference information based on the update information and stores the updated reference information in the memory 23M. This can improve the accuracy of the battery state detection.

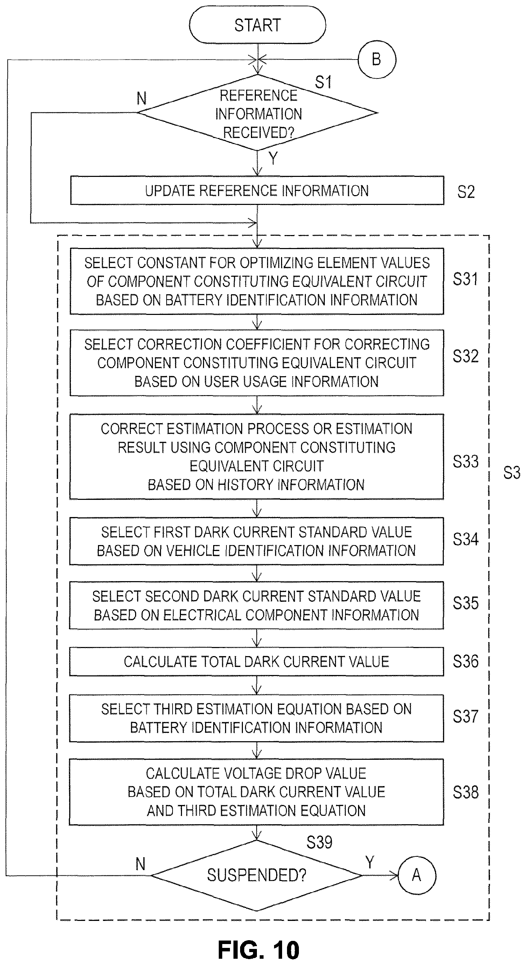

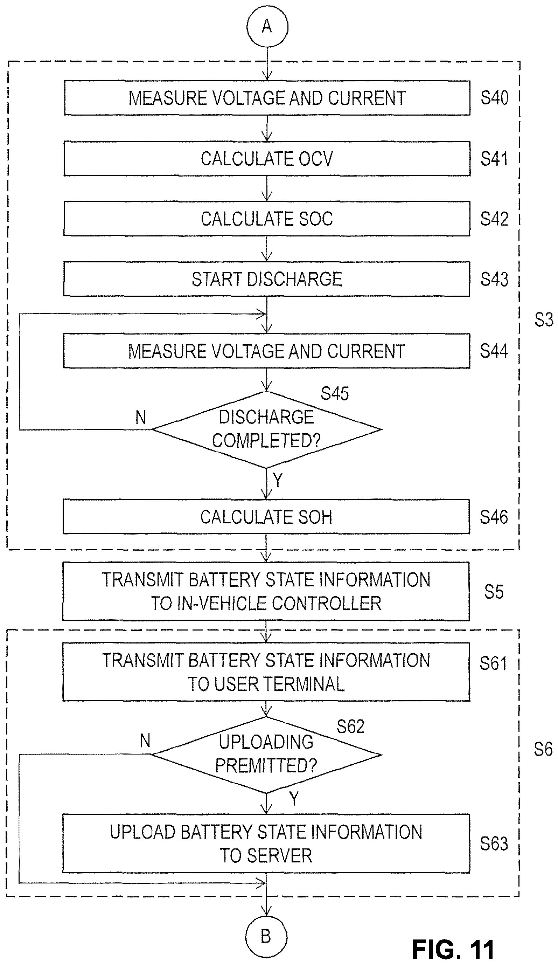

With reference to FIGS. 10 and 11, the operation of the battery state detection device 10 and the information processing system 50 will be described.

As shown in FIG. 10, whether the reference information has been received from the user terminal 41 via the communication unit 30 is determined by the estimator 23 of the battery state detection unit 20 (step S1). In a case where the reference information is received, the reference information stored in the memory 23M is updated with the newly received reference information (step S2). Specifically, the battery identification information, the electrical component information, the user usage information, the history information, and the vehicle identification information are updated by the estimator 23 based on the received reference information. In a case where the reference information has not been received, the process proceeds to step S3 without updating the reference information.

Based on the reference information, the estimation process information (the estimation equation and the parameters) is corrected by the estimator 23 (step S3). Specifically, the constant for optimizing the element values of the equivalent circuit is obtained by the estimator 23 based on the size included in the battery identification information (step S31). More specifically, the constant corresponding to the size included in the battery identification information is selected by the estimator 23 from the plurality of constants stored in the memory 23M. Also, based on the user usage information, the estimator 23 selects the correction coefficient for correcting the component constituting the equivalent circuit (step S32). Specifically, from the plurality of correction coefficient stored in the memory 23M, the correction coefficient corresponding to the usage pattern included in the user usage information is selected by the estimator 23.

Based on the history information, the estimation process or the estimation result which uses the component constituting the equivalent circuit is corrected by the estimator 23 (step S33). Specifically, in a case where the history information indicates that the rechargeable battery 4 has been replaced, the usage pattern A is selected by the estimator 23 as the usage pattern.

The estimation process information is corrected by the estimator 23 based on the vehicle identification information. Specifically, from the plurality of first dark current standard values stored in the memory 23M, the dark current standard value corresponding to the model and the grade included in the vehicle identification information is selected by the estimator 23 (step S34).

The estimated process information is corrected by the estimator 23 based on the electrical component information. Specifically, from the plurality of second dark current standard values stored in the memory 23M, the dark current standard value corresponding to an electrical component included in the electrical component information is selected by estimator 23 (step S35). The sum of the selected first dark current standard value and the selected at least one second dark current standard value is calculated by the estimator 23 as the total dark current value (step S36).

From the plurality of third estimation equations (relational expression between the dark current value and the voltage drop value) stored in the memory 23M, the estimator 23 selects the estimation equation corresponding to the battery type included in the battery identification information (step S37). Based on the total dark current value and the selected third estimation equation, the voltage drop value is calculated by the estimator 23 (step S38).

Whether the rechargeable battery 4 is in the state where the charging and discharging are suspended is determined by the estimator 23 (step S39). In a case where the rechargeable battery 4 is not in the state where the charging and discharging are suspended, steps S1 to S38 are repeated (step S39).

On the other hand, as shown in FIG. 11, in the case where the rechargeable battery 4 is in the state where the charging and discharging are suspended, the voltage and the current of the rechargeable battery 4 are measured by the voltage sensor 22A and the current sensor 22B (step S40). The measured voltage and the measured current are temporarily stored in the memory 23M. The OCV is calculated by the estimator 23 by adding the voltage drop value to the measured voltage (step S41). The SOC is calculated by the estimator 23 based on the OCV and the fourth estimation equation (step S42).

In the state where the charging and discharging of the rechargeable battery 4 are suspended, pulse discharge of the rechargeable battery 4 is started by the discharge circuit 24 (step S43). The voltage and the current of the rechargeable battery 4 are measured by the voltage sensor 22A and the current sensor 22B (step S44). The voltage and the current are repeatedly measured until the pulse discharge is completed (step S45). After the pulse discharge is completed, the SOH of the rechargeable battery 4 is calculated by the estimator 23 using the equations (3) to (13) (step S46). The calculated SOC and SOH are transmitted to the in-vehicle controller 8A via the communication unit 30 (step S5).

To collect the battery state information from a plurality of vehicles, the calculated SOC and SOH are uploaded to the server 42 via the Internet (step S6). Specifically, the data collection method comprises: a step of obtaining the battery state information using the battery state detection device 10 configured to detect the state of the rechargeable battery 4 installed to the vehicle 2 (steps S1 to S46); a step of transmitting the battery state information to the user terminal 41 using the battery state detection device 10 (step S61); a step of inquiring of the user, using the user terminal, whether or not to permit uploading of the battery state information (step S62); and a step of uploading the battery state information to the server 42 using the user terminal 41 in a case where the user permits the uploading (step S63). In a case where the user does not permit the uploading, the battery state information is not uploaded from the user terminal 41 to the server 42 and the process returns to step S1 (step S62). In the case where the user permits the uploading, the latest battery state information is uploaded from the user terminal 41 to the server 42 each time the battery state information is updated (step S63). The battery state information may be uploaded from the communication unit 30 to the server 42 via the Internet instead of from the user terminal 41.

(A1) As described above, the battery state detection device 10 comprises the sensor 22, the communicator 32, and the estimator 23. The sensor 22 measures at least one of the voltage, the current, and the temperature of the rechargeable battery 4 installed to the vehicle 2. The communicator 32 is configured to obtain the reference information relating to the battery state detection from the external device 40. The estimator 23 is configured to estimate the state of the rechargeable battery 4 based on the measured value of the sensor 22. The estimator 23 is configured to correct at least one of the estimation equation and the parameter based on the reference information.

With the battery state detection device 10, since the estimator 23 corrects at least one of the estimation equation and the parameter based on the reference information obtained from the external device 40, the reference information can be updated depending on the rechargeable battery 4 via the external device 40, enabling the accuracy of the battery state detection to be improved.

(A2) The reference information includes at least one of the battery identification information to identify the rechargeable battery 4, the electrical component information relating to the electrical component which has been custom-installed to the vehicle 2, the user usage information relating to at least one of the vehicle usage frequency and the vehicle usage method of the user, and the history information relating to at least one of the replacement history and the reconnection history of the rechargeable battery 4. Therefore, it is possible to further improve the accuracy of the battery state detection by using at least one of the battery identification information, the electrical component information, the user usage information, and the history information.

(A3) The battery state detection device 10 further comprises the discharge circuit 24. The estimator 23 is configured to obtain the component constituting the equivalent circuit of the rechargeable battery 4 based on the response when the pulsed current flows through the discharge circuit 24. The estimator 23 is configured to estimate the state of the rechargeable battery 4 based on the component constituting the equivalent circuit. Thus, it is possible to improve the accuracy of the estimation of the battery state information by the estimation based on the equivalent circuit model which utilize pulse discharge.

(A4) The reference information includes the battery identification information enabling the rechargeable battery 4 to be identified. The estimator 23 is configured to correct the component constituting the equivalent circuit based on the battery identification information. Thus, it is possible to further improve the accuracy of the estimation of the battery state information by correcting the component constituting the equivalent circuit using the battery identification information.

(A5) The reference information includes the electrical component information relating to the electrical component which has been custom-installed to the vehicle 2. The estimator 23 is configured to correct the estimation process information relating to the estimation of the state of the rechargeable battery 4 based on the electrical component information. Thus, it is possible to further improve the accuracy of the estimation of the battery state information by correcting the estimation process information using the electrical component information.

(A6) The reference information includes the user usage information relating to at least one of the vehicle usage frequency and the vehicle usage method of the user. The estimator 23 is configured to select, based on the user usage information, the correction coefficient for correcting the component constituting the equivalent circuit. Therefore, it is possible to further improve the accuracy of the estimation of the battery state information by selecting the correction coefficient for correcting the equivalent circuit using the user usage information.

(A7) The reference information includes the history information indicating at least one of the replacement history and the reconnection history of the rechargeable battery 4. The estimator 23 is configured to correct, based on the history information, the estimation process or the estimation result which uses the component constituting the equivalent circuit. Therefore, it is possible to further improve the accuracy of the estimation of the battery state information by correcting, based on the history information, the estimation process or the estimation result which uses the component constituting the equivalent circuit.

(A8) The communicator 32 is provided separately from at least one of the sensor 22 and the estimator 23 and is configured to be detachably attached to at least one of the sensor 22 and the estimator 23. Thus, it is possible to attach the communicator 32 to a configuration which does not have a communicator by providing the communicator 32 separately from at least one of the sensor 22 and the estimator 23, which improves convenience.

The communicator 32 may be provided as a single unit with at least one of the sensors 22 and the estimator 23. For example, the communication unit 30 may be provided as a single unit with the battery state detection unit 20.

(A9) The information processing system 50 comprises the battery state detection device 10 according to any one of the first to eighth aspects, the user terminal 41 configured to communicate wirelessly with the communicator 32 of the battery state detection device 10, and the server 42 configured to be connected to the battery state detection device 10 and the user terminal 41 via the Internet.

With the information processing system 50, since the communication unit and the user terminal 41 are connected to the server 42 via the Internet, the battery state information can be transmitted to the server 42 for effective use.

(B1) The communication unit 30 comprises the first connection part 31, the information communicator 33, and the wireless communicator 34. The first connection part 31 is configured to be attached to the battery state detection unit 20 configured to detect the battery state information indicating the state of the rechargeable battery 4 installed to the vehicle 2 and is electrically connected to the battery state detection unit 20 in a state where the first connection part 31 is attached to the battery state detection unit 20. The information communicator 33 is configured to obtain the battery state information from the battery state detection unit 20 via the first connection part 31. The wireless communicator 34 is configured to wirelessly transmit the battery state information obtained by the information communicator 33 to the external device 40.

With the communication unit 30, since the first connection part 31 is configured to be detachably attached to the battery state detection unit 20, the communication unit 30 can be attached to the battery state detection unit 20 via the first connection part 31. Therefore, the communication unit 30 can be attached to the existing battery state detection unit 20, thereby improving the convenience of the battery state detection unit 20 while reducing the increase in cost.

(B2) The information communicator 33 includes the first wired communicator 35 and the second wired communicator 36. The first wired communicator 35 is configured to receive the battery state information from the battery state detection unit 20 by wired communication via the first connection part 31. The second wired communicator 36 is configured to transmit the battery state information to the in-vehicle controller 8A of the vehicle 2 by wired communication. Thus, the battery state information can be transmitted to the in-vehicle controller 8A as well as the external device 40. This enables the battery state information to be transmitted to the external device 40 while maintaining the control of the vehicle 2 using the battery state information.

(B3) The communication unit 30 further comprises the second connection part 37. The second connection part 37 is electrically connectable to the in-vehicle controller 8A. The second wired communicator 36 is configured to transmit the battery state information to the in-vehicle controller 8A via the second connection part 37 by wired communication. Therefore, the second connection part 37 enables the connection with the in-vehicle controller 8A can be reliably realized.

(B4) Since the shape of the second connection part 37 is complementary to the shape of the first connection part 31, a part (e.g., a harness) which is connectable to the second connection part 37 can be directly connected to the battery state detection unit 20. Therefore, it is possible to make both a configuration in which a wire harness of the vehicle 2 is directly connected to the battery state detection unit 20 and a configuration in which the wire harness of vehicle 2 is connected to the battery state detection unit 20 via the communication unit 30 compatible.

(B5) The first wired communicator 35 is configured to receive the battery state information from the battery state detection unit 20 via the first connection part 31 by wired communication using the first protocol. The second wired communicator 36 is configured to transmit the battery state information to the in-vehicle controller 8A by wired communication using the second protocol different from the first protocol. Thus, it is possible to transmit and receive the information relating to the battery state detection between networks with different protocols.

(B6) The wireless communicator 34 is configured to wirelessly receive the reference information relating to the battery state detection from the external device 40. The information communicator 33 transmits the reference information received by the wireless communicator 34 to at least one of the in-vehicle controller 8A and the battery state detection unit 20. It is possible to update information depending on the rechargeable battery 4 and to improve the accuracy of the battery state information by transmitting the reference information obtained from the external device 40 to at least one of the in-vehicle controller 8A and the battery state detection unit 20.

(B7) Since the wireless communicator 34 is configured to perform wireless communication using at least one of the Bluetooth standard and the Wi-Fi standard, it is possible to use the highly versatile user terminal 41 such as a smartphone or a tablet computer as the external device 40. Thus, the convenience of the battery state detection device 10 is improved.

(B8) The wireless communicator 34 is configured to upload the battery state information obtained by the information communicator 33 to the server 42. Therefore, it is possible to effectively utilize the battery state information to improve the accuracy of the battery state detection by analyzing the battery state information obtained from a plurality of battery state detection devices 10 at the server 42.

(B9) The communication unit 30 further comprises the housing 38 which houses the information communicator 33. The housing 38 includes the rotation stopper contactable with the side of the rechargeable battery 4. This enables the posture of the communication unit 30 to be stable with respect to the rechargeable battery 4.

(B10) The battery state detection device 10 comprises the battery state detection unit 20 and the communication unit 30 according to any one of the first to ninth aspects. The battery state detection unit 20 includes the battery connection part, the voltage sensor, the current sensor, the temperature sensor, and the estimator 23. The battery connection part unit is attachable to the terminal of the rechargeable battery 4. The voltage sensor is configured to measure the voltage of the rechargeable battery 4. The current sensor is configured to measure the current of the rechargeable battery 4. The temperature sensor is configured to measure the temperature of the rechargeable battery 4. The estimator 23 is configured to estimate the state of the rechargeable battery 4 based on at least one of the measured voltage of the voltage sensor, the measured current of the current sensor, and the measured temperature of the temperature sensor. The information communicator 33 of the communication unit 30 is configured to obtain, as the battery state information, at least one of the measured voltage, the measured current, the measured temperature, and the estimation result of the estimator 23 via the first connection part 31.

With the battery state detection device 10, even if the battery state detection unit 20 does not have a wireless transmission function, by connecting the communication unit 30 to the battery state detection unit 20, the battery state information can be transmitted wirelessly to the external device 40 via the communication unit 30. Therefore, the communication unit 30 can improve the convenience of the battery state detection unit 20.

(B11) In accordance with the eleventh aspect, in the battery state detection device 10 according to the tenth aspect, the battery state detection unit 20 includes the discharge circuit 24. The estimator 23 is configured to obtain the component constituting the equivalent circuit of the rechargeable battery 4 based on the response when the pulsed current flows through the discharge circuit 24. The estimator 23 is configured to estimate the state of the rechargeable battery 4 based on the component constituting the equivalent circuit. The estimation based on the equivalent circuit model utilizing pulse discharge can improve the accuracy of the estimation of the battery state information.

(B12) The wireless communicator 34 is configured to wirelessly receive the reference information relating to the battery state detection from the external device 40. The estimator 23 is configured to correct the estimation process information relating to the estimation of the state of the rechargeable battery 4 based on the reference information. It is possible to correct the estimated processing information depending on the rechargeable battery 4 and then to improve the accuracy of detecting the battery state information by using the reference information.

(B13) The reference information includes at least one of the battery identification information enabling the rechargeable battery 4 to be identified, the electrical component information relating to the electrical component which has been custom-installed to the vehicle 2, the user usage information relating to at least one of the vehicle usage frequency and the vehicle usage method of the user, and the history information relating to at least one of the replacement history and the reconnection history of the rechargeable battery 4 It is possible to further improve the accuracy of the battery state detection by using at least one of the battery identification information, the electrical component information, the user usage information, and the history information.

(B14) The information processing system 50 comprises the communication unit 30 according to any one of the first to ninth aspects, the user terminal 41 configured to communicate wirelessly with the wireless communicator 34 of the communication unit 30, and the server 42 configured to be connected to the communication unit 30 and the user terminal 41 via the Internet.

With the information processing system 50, since the communication unit 30 and the user terminal 41 are connected to the server 42 via the Internet, the battery state information can be transmitted to the server 42 and then effectively utilized.

(B15) The data collection method comprises: a step of obtaining the battery state information using the battery state detection device 10 configured to detect the state of the rechargeable battery 4 installed to the vehicle 2; a step of transmitting the battery state information to the user terminal 41 using the battery state detection device 10; a step of inquiring of the user, using the user terminal, whether or not to permit uploading of the battery state information; and a step of uploading the battery state information to the server 42 using the user terminal 41 in a case where the user permits the uploading.

With the data collection method, since the communication unit 30 and the user terminal 41 are connected to the server 42 via the Internet, the battery state information can be transmitted to the server 42 and then effectively utilized.

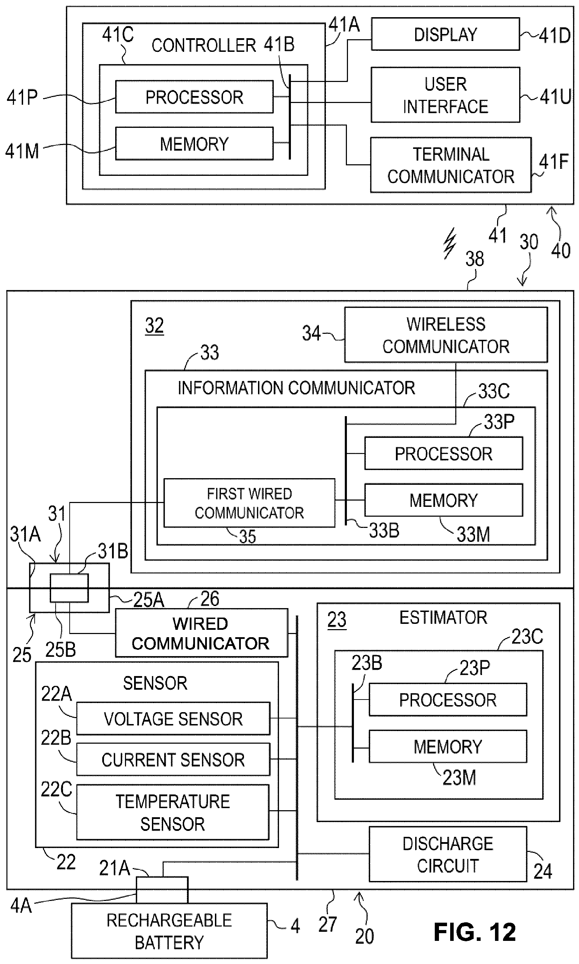

In the aforementioned embodiment, although the information communicator 33 includes the second wired communicator 36, as shown in FIG. 12, the second wired communicator 36 may be omitted from the information communicator 33. In this case, the second connection part 37 is omitted from the communication unit 30. The communication unit 30 in accordance with the modification shown in FIG. 12 can be attached to the battery state detection unit 20 which does not have a configuration which communicates with the in-vehicle controller. Similar to the aforementioned embodiment, in the case of the modification shown in FIG. 12, the first connection part 31 may be configured to be detachably attached to the battery state detection unit 20, and the first connection part 31 may be configured not to be detached from the battery state detection unit 20 after the first connection part 31 is attached to the battery state detection unit 20.

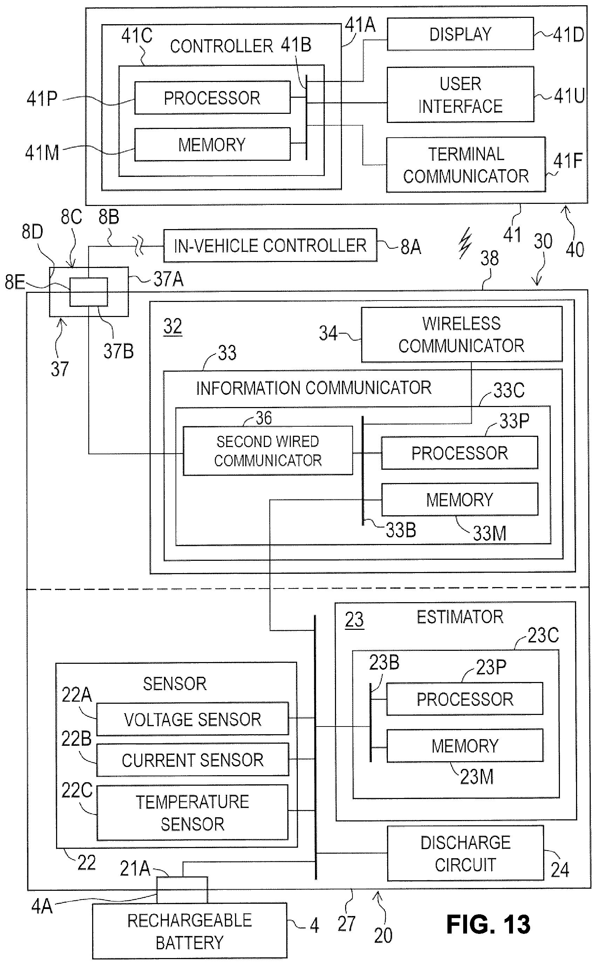

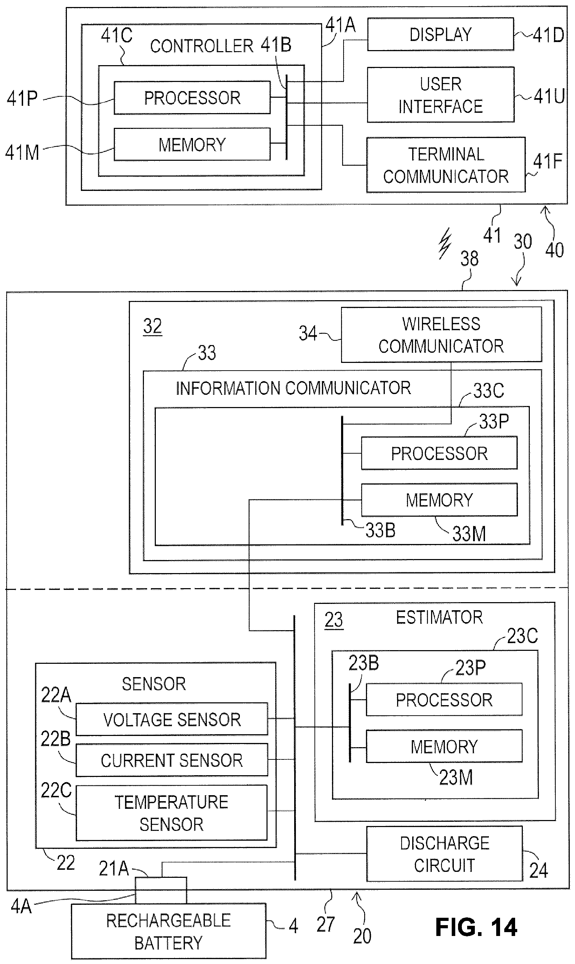

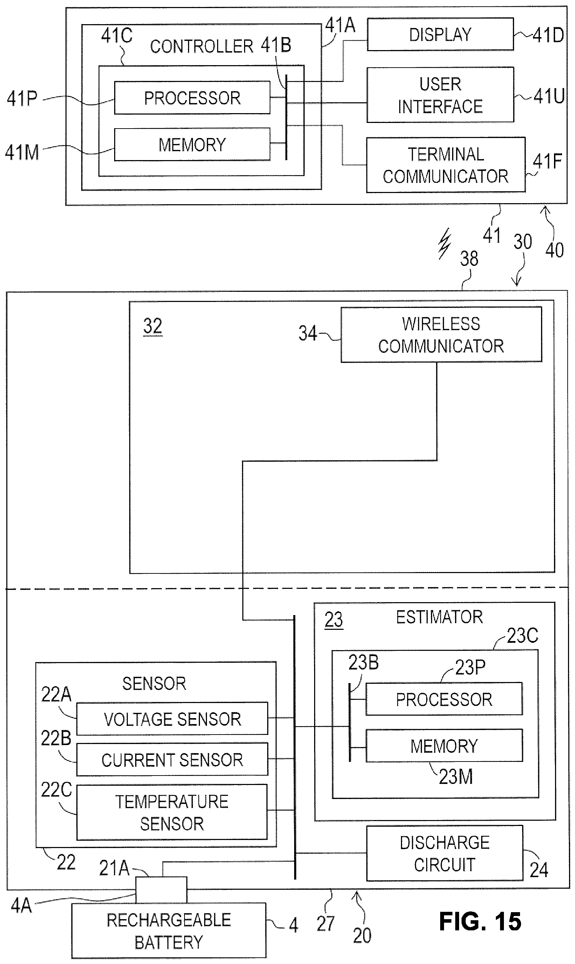

As shown in FIGS. 13 to 15, the communication unit 30 may be configured as a single unit with the battery state detection unit 20. As shown in FIGS. 13 to 15, in a case where the battery state detection unit 20 and the communication unit 30 are configured as a single unit, for example, the first wired communicator 35 and the first connection part 30 are omitted from the communication unit 30. In the modification shown in FIGS. 13 and 14, the information communicator 33 of the communicator 32 is electrically connected to the sensor 22 and the estimator 23. In the modification shown in FIG. 14, the second wired communicator 36 and the second connection part 37 are omitted from the communication unit 30. In the modification shown in FIG. 15, the information communicator 33 is omitted from the communicator 32, and the wireless communicator 34 is electrically connected to the sensor 22 and the estimator 23. In this case, for example, the processor 23P of the estimator 23 may be configured to control the wireless communicator 34.

The devices described in Patent Literatures 1 and 2 have a pre-installed communicator which communicates externally.

However, since the technology described in Patent Literature 1 is not compatible with a secondary battery charge control device which does not have a communicator, for vehicles equipped with the secondary battery charge control device which does not have the communicator, the secondary battery charge control device itself which does not have the communicator must be replaced with the secondary battery charge control device having the communicator. This increases the economic burden on the user.

Another object of the technology disclosed in the present application is to improve the convenience of the battery state detection device while reducing an increase in cost.

In accordance with a first aspect, a communication unit comprises a first connection part unit, an information communicator, and a wireless communicator. The first connection part is configured to be attached to a battery state detection unit configured to detect battery state information indicating a state of a rechargeable battery installed to a vehicle and is electrically connected to the battery state detection unit in a state where the first connection part is attached to the battery state detection unit. The information communicator is configured to obtain the battery state information from the battery state detection unit via the first connection part. The wireless communicator is configured to wirelessly transmit the battery state information obtained by the information communicator to an external device.

With the communication unit according to the first aspect, since the first connection part is configured to be detachably attached to the battery state detection unit, the communication unit can be attached to the battery state detection unit via the first connection part. Therefore, the communication unit can be attached to an existing battery state detection unit, thereby improving the convenience of the battery state detection unit while reducing an increase in cost.

In accordance with a second aspect, in the communication unit according to the first aspect, the information communicator includes a first wired communicator and a second wired communicator. The first wired communicator is configured to receive the battery state information from the battery state detection unit via the first connection part by wired communication. The second wired communicator is configured to transmit the battery state information to the in-vehicle controller of the vehicle by wired communication.

With the communication unit according to the second aspect, it is possible to transmit the battery state information not only to the external device but also to the in-vehicle controller. This enables the battery state information to be transmitted to the external device while maintaining the control of the vehicle using the battery state information.

In accordance with a third aspect, the communication unit according to the second aspect further comprises a second connection part. The second connection part is electrically connectable to the in-vehicle controller. The second wired communicator is configured to transmit the battery state information to the in-vehicle controller via the second connection part by wired communication.

With the communication unit according to the third aspect, the second connection part enables the connection with the in-vehicle controller to be reliably realized.

In accordance with a fourth aspect, in the communication unit according to the third aspect, a shape of the second connection part is complementary to a shape of the first connection part.

With the communication unit according to the fourth aspect, a part (e.g., a harness) which is connectable to the second connection part to the battery state detection unit. Therefore, it is possible to make both a configuration in which the vehicle wire harness is directly connected to the battery state detection unit and a configuration in which the wire harness of the vehicle is connected to the battery state detection unit via the communication unit compatible.

In accordance with a fifth aspect, in the communication unit according to any one of the second to fourth aspects, the first wired communicator is configured to receive the battery state information from the battery state detection unit via the first connection part unit by wired communication using the first protocol. The second wired communicator is configured to transmit the battery state information to the in-vehicle controller by wired communication using a second protocol different from the first protocol.

With the communication unit according to the fifth aspect, it is possible to transmit and receive information relating to the battery state detection between networks with different protocols.

In accordance with a sixth aspect, in the communication unit according to any one of the second to fifth aspects, the wireless communicator is configured to wirelessly receive the reference information relating to the battery state detection from the external device. The information communicator transmits the reference information received by the wireless communicator to at least one of the in-vehicle controller and the battery state detection unit.

With the communication unit according to the sixth aspect, it is possible to update information depending on the rechargeable battery and then to improve the accuracy of the battery state information by transmitting the reference information obtained from the external device to at least one of the in-vehicle controller and the battery state detection unit.

In accordance with a seventh aspect, in the communication unit according to any one of the first to sixth aspects, the wireless communicator is configured to perform wireless communication using at least one of a Bluetooth standard and a Wi-Fi standard.

With the communication unit according to the seventh aspect, it is possible to use a highly versatile user terminal such as a smartphone and a tablet computer as the external device. Thus, the convenience of the battery state detection device is improved.

In accordance with an eighth aspect, in the communication unit according to any one of the first to seventh aspects, the wireless communicator is configured to upload the battery state information obtained by the information communicator to a server.

With the communication unit according to the eighth aspect, it is possible to effectively utilize the battery state information to improve the accuracy of the battery state detection by analyzing the battery state information obtained from a plurality of battery state detection devices in the server.

In accordance a ninth aspect, the communication unit according to any one of the first through the eighth aspects further comprises a housing which houses the information communicator. The housing includes a rotation stopper contactable with a side of the rechargeable battery.

With the communication unit according to the ninth aspect, it is possible to stabilize the posture of the communication unit with respect to the rechargeable battery.

In accordance with a tenth aspect, a battery state detection device comprises a battery state detection unit and a communication unit according to any one of the first to ninth aspects. The battery state detection unit includes a battery connection part, a voltage sensor, a current sensor, a temperature sensor, and an estimator. The battery connection part unit is attachable to a terminal of the rechargeable battery. The voltage sensor is configured to measure a voltage of the rechargeable battery. The current sensor is configured to measure a current of the rechargeable battery. The temperature sensor is configured to measure a temperature of the rechargeable battery. The estimator is configured to estimate a state of the rechargeable battery based on at least one of a measured voltage of the voltage sensor, a measured current of the current sensor, and a measured temperature of the temperature sensor. The information communicator of the communication unit is configured to obtain, as the battery state information, at least one of the measured voltage, the measured current, the measured temperature, and an estimation result of the estimator via the first connection part.

With the battery state detection device according to the tenth aspect, even if the battery state detection unit does not have a wireless transmission function, by connecting a communication unit to the battery state detection unit, the battery state information can be transmitted wirelessly to the external device via the communication unit. Therefore, the communication unit can improve the convenience of the battery state detection unit.

In accordance with an eleventh aspect, in the battery state detection device according to the tenth aspect, the battery state detection unit includes a discharge circuit. The estimator is configured to obtain a component constituting an equivalent circuit of the rechargeable battery based on a response when a pulsed current flows through the discharge circuit. The estimator is configured to estimate the state of the rechargeable battery based on the component constituting the equivalent circuit.

With the battery state detection device according to the eleventh aspect, it is possible to improve the accuracy of the estimation of the battery state information by the estimation based on an equivalent circuit model which utilizes pulse discharge.

In accordance with a twelfth aspect, in the battery state detection device according to the tenth or eleventh aspect, the wireless communicator is configured to wirelessly receive reference information relating to the battery state detection from the external device. The estimator is configured to correct the estimation process information relating to an estimation of the state of the rechargeable battery based on the reference information.

With the battery state detection device according to the twelfth aspect, it is possible to correct the estimated processing information depending on the rechargeable battery and then to improve the accuracy of detecting the battery state information by using the reference information.

In accordance with a thirteenth aspect, in the battery state detection device according to the twelfth aspect, the reference information includes at least one of battery identification information enabling the rechargeable battery to be identified, electrical component information relating to the electrical component which has been custom-installed to the vehicle, user usage information relating to at least one of vehicle usage frequency and a vehicle usage method of a user, and history information relating to at least one of replacement history and reconnection history of the rechargeable battery.

With the battery state detection device according to the thirteenth aspect, it is possible to further improve the accuracy of the battery state detection by using at least one of the battery identification information, the electrical component information, the user usage information, and the history information.

In accordance with a fourteenth aspect, an information processing system comprises the communication unit according to any one of the first to ninth aspects, a user terminal configured to communicate wirelessly with a wireless communicator of the communication unit, and a server configured to be connected to the communication unit and the user terminal via the Internet.

With the information processing system according to the fourteenth aspect, since the communication unit and the user terminal are connected to the server via the Internet, the battery state information can be transmitted to the server and then effectively utilized.

In accordance with the fifteenth aspect, the data collection method comprises: a step of obtaining battery state information using a battery state detection device configured to detect a state of a rechargeable battery installed to a vehicle; a step of transmitting the battery state information to the user terminal using the battery state detection device; a step of inquiring of the user, using the user terminal, whether or not to permit uploading of the battery state information; and a step of uploading the battery state information to a server by the user terminal when the user permits the uploading.

With the data collection method according to the fifteenth aspect, since the communication unit and the user terminal are connected to the server via the Internet, the battery state information can be transmitted to the server and then effectively utilized.

With the technology disclosed in the present application, it is possible to improve the convenience of the battery state detection unit while reducing an increase in cost.

In the present application, the term "comprising" and its derivatives are open-ended terms that describe the presence of constituent elements and do not exclude the presence of other constituent elements not described. This concept also applies to the terms "having," "including," and their derivatives.

In the present application, ordinal numbers such as "first" and "second" are merely identifiers, but do not have any other meanings (e.g., a particular order and the like). For example, the term "first element" does not imply an existence of "second element," and the term "second element" does not imply an existence of "first element.

Terms of degree such as "substantially," "about," and "approximately" can mean a reasonable amount of deviation such that the end result is not significantly changed. All numeral values described in the present application can be interpreted to include the terms such as "substantially," "about," and "approximately," etc.

The phrase "at least one of A and B" in the present disclosure encompasses, for example, (1) A alone, (2) B alone, and (3) both A and B. The phrase "at least one of A, B, and C" encompasses, for example, (1) A alone, (2) B alone, (3) C alone, (4) A and B, (5) B and C, (6) A and C, and (7) all A, B, and C. In the present disclosure, the phrase "at least one of A and B" is not to be interpreted as "at least one of A and at least one of B."

In view of the above disclosure, it is obvious that various changes and modifications of the present invention are possible. Therefore, the present invention may be implemented in a manner different from that of the specific disclosure of the present application to the extent that it does not depart from the intent of the present invention.

Reference Signs List

2: Vehicle
4: Rechargeable battery
8: Load
8A: In-vehicle controller
8B: Wire harness
10: Battery state detection device
19: Load
20: Battery state detection unit
22: Sensor
22A: Voltage sensor
22B: Current sensor
22C: Temperature sensor
23: Estimator
24: Discharge circuit
30: Communication unit
31: First connection part
32: Communicator
33: Information Communicator

34: Wireless communicator
35: First wired communicator
36: Second wired communicator
37: Second connection part
38: Housing
38A: Rotation stopper
40: External device
41: User terminal
42: Server
50: Information processing system

**Claims**

1. A battery state detection device comprising:

   a sensor which measures at least one of a voltage, a current, and a temperature of a rechargeable battery installed to a vehicle;
   a communicator configured to obtain reference information relating to battery state detection from an external device;
   an estimator configured to estimate a state of the rechargeable battery based on a measured value of the sensor; and
   the estimator being configured to correct at least one of an estimation equation and a parameter based on the reference information.

2. The battery state detection device according to claim 1, wherein the reference information includes at least one of

   battery identification information enabling the rechargeable battery to be identified,
   electrical component information relating to an electrical component which has been custom-installed to the vehicle,
   user usage information relating to at least one of vehicle usage frequency and a vehicle usage method of a user, and
   history information relating to at least one of replacement history and reconnection history of the rechargeable battery.

3. The battery state detection device according to claim 1 or 2, further comprising:

   a discharge circuit, wherein
   the estimator is configured to obtain a component constituting an equivalent circuit of the rechargeable battery based on a response when a pulsed current flows through the discharge circuit, and
   the estimator is configured to estimate the state of the rechargeable battery based on the component constituting the equivalent circuit.

4. The battery state detection device according to claim 3, wherein

   the reference information includes battery identification information enabling the rechargeable battery to be identified, and
   the estimator is configured to correct the component constituting the equivalent circuit based on the battery identification information.

5. The battery state detection device according to any one of claims 1 to 4, wherein

   the reference information includes electrical component information relating to an electrical component which has been custom-installed to the vehicle, and
   the estimator is configured to correct estimation process information relating to an estimation of the state of the rechargeable battery based on the electrical component information.

6. The battery state detection device according to claim 3 or 4, wherein

the reference information includes user usage information relating to at least one of vehicle usage frequency of a user and a vehicle usage method of the user, and

the estimator is configured to select, based on the user usage information, a correction coefficient for correcting the component constituting the equivalent circuit.

7. The battery state detection device according to claim 3 or 4, wherein

the reference information includes history information indicating at least one of replacement history and reconnection history of the rechargeable battery, and

the estimator is configured to correct, based on the history information, an estimation process or an estimation result which uses the component constituting the equivalent circuit.

8. The battery state detection device according to any one of claims 1 to 7, wherein the communicator is provided separately from at least one of the sensor and the estimator and is configured to be detachably attached to at least one of the sensor and the estimator.

9. The battery state detection device according to any one of claims 1 to 8, further comprising:

a battery state detection unit configured to detect battery state information indicating the state of the rechargeable battery; and

a communication unit, wherein

the battery state detection unit includes the sensor and the estimator,

the communication unit includes

the communicator, and

a first connection part configured to be attached to the battery state detection unit, the first connection part being electrically connected to the battery state detection unit in a state where the first connection part is attached to the battery state detection unit, and

the communicator includes

an information communicator configured to obtain the battery state information from the battery state detection unit via the first connection part, and

a wireless communicator configured to wirelessly transmit the battery state information obtained by the information communicator to the external device.

10. The battery state detection device according to claim 9, wherein the information communicator includes

a first wired communicator configured to receive the battery state information from the battery state detection unit via the first connection part by wired communication, and

a second wired communicator configured to transmit the battery state information to an in-vehicle controller of the vehicle by wired communication.

11. The battery state detection device according to claim 10, further comprising:

a second connection part electrically connectable to the in-vehicle controller, wherein

the second wired communicator is configured to transmit the battery state information to the in-vehicle controller via the second connection part by wired communication.

12. The battery state detection device according to claim 11, wherein a shape of the second connection part is complementary to a shape of the first connection part.

13. The battery state detection device according to any one of claims 10 to 12, wherein

the first wired communicator is configured to receive the battery state information by wired communication from the battery state detection unit via the first connection part using a first protocol, and

the second wired communicator is configured to transmit the battery state information to the in-vehicle controller by wired communication using a second protocol different from the first protocol.

**14.** The battery state detection device according to any one of claims 10 to 13, wherein

the wireless communicator is configured to wirelessly receive the reference information relating to the battery state detection from the external device, and
the information communicator transmits the reference information received by the wireless communicator to at least one of the in-vehicle controller and the battery state detection unit.

**15.** The battery state detection device according to any one of claims 9 to 14, wherein
the wireless communicator is configured to wirelessly communicate using at least one of a Bluetooth standard and a Wi-Fi standard.

**16.** The battery state detection device according to any one of claims 9 to 15, wherein
the wireless communicator is configured to upload the battery state information obtained by the information communicator to a server.

**17.** The battery state detection device according to any one of claims 9 to 16, further comprising:

a housing which houses the information communicator, wherein
the housing includes a rotation stopper contactable with a side of the rechargeable battery.

**18.** The battery state detection device according to any one of claims 9 to 17, wherein

the battery state detection unit includes a battery connection part attachable to a terminal of the rechargeable battery,
the sensor includes

a voltage sensor configured to measure a voltage of the rechargeable battery,
a current sensor configured to measure a current of the rechargeable battery, and
a temperature sensor configured to measure a temperature of the rechargeable battery,

the estimator is configured to estimate the state of the rechargeable battery based on at least one of a measured voltage of the voltage sensor, a measured current of the current sensor, and a measured temperature of the temperature sensor, and
the information communicator of the communication unit is configured to obtain, as the battery state information, at least one of the measured voltage, the measured current, the measured temperature, and an estimation result of the estimator via the first connection part.

**19.** The battery state detection device according to claim 18, wherein

the battery state detection unit includes a discharge circuit,
the estimator is configured to obtain a component constituting an equivalent circuit of the rechargeable battery based on a response when a pulsed current flows through the discharge circuit, and
the estimator is configured to estimate the state of the rechargeable battery based on the component constituting the equivalent circuit.

**20.** The battery state detection device according to claim 18 or 19, wherein the wireless communicator is configured to wirelessly receive the reference information relating to battery state detection from the external device, and
the estimator is configured to correct estimation process information relating to an estimation of the state of the rechargeable battery based on the reference information.

**21.** An information processing system comprising:

the battery state detection device according to any one of claims 1 to 20;
a user terminal configured to wirelessly communicate with the communicator of the battery state detection device; and
a server configured to be connected to the battery state detection device and the user terminal via the Internet.

**22.** A data collection method comprising:

a step of obtaining battery state information using a battery state detection device configured to detect a state of a rechargeable battery installed to a vehicle;

a step of transmitting the battery state information to a user terminal using the battery state detection device;

a step of inquiring of a user, using the user terminal, whether or not to permit uploading of the battery state information; and

a step of uploading the battery state information to the server using the user terminal in a case where the user permits the uploading.

**FIG. 1**

EP 4 450 333 A1

**FIG. 2**

**FIG. 3**

EP 4 450 333 A1

FIG. 4

| BATTERY SIZE | CONSTANT |
|:---:|:---:|
| SIZE 1 | B1 |
| SIZE 2 | B2 |
| . | . |
| . | . |
| . | . |
| SIZE N | BN |

**FIG. 5**

| USAGE PATTERN | CORRECTION COEFFICIENT |
|---|---|
| USAGE PATTERN A | f_Rohm_A, f_Rct1_A, f_Rct2_A, f_C1_A, f_C2_A |
| USAGE PATTERN B | f_Rohm_B, f_Rct1_B, f_Rct2_B, f_C1_B, f_C2_B |
| USAGE PATTERN C | f_Rohm_C, f_Rct1_C, f_Rct2_C, f_C1_C, f_C2_C |
| USAGE PATTERN D | f_Rohm_D, f_Rct1_D, f_Rct2_D, f_C1_D, f_C2_D |
| USAGE PATTERN E | f_Rohm_E, f_Rct1_E, f_Rct2_E, f_C1_E, f_C2_E |

**FIG. 6**

| MODEL | GRADE | FIRST DARK CURRENT STANDARD VALUE [mA] |
|---|---|---|
| MODEL 1 | GRADE 1 | A11 |
| | GRADE 2 | A12 |
| | . | . |
| | GRADE N | A1N |
| MODEL 2 | GRADE 1 | A21 |
| | GRADE 2 | A22 |
| | . | . |
| | GRADE N | A2N |
| MODEL 3 | GRADE 1 | A31 |
| | GRADE 2 | A32 |
| | . | . |
| | GRADE N | A3N |

**FIG. 7**

EP 4 450 333 A1

| ELECTRICAL COMPONENT | SECOND DARK CURRENT STANDARD VALUE [mA] |
|---|---|
| ELECTRICAL COMPONENT 1 | D21 |
| ELECTRICAL COMPONENT 2 | D22 |
| . | . |
| . | . |
| . | . |
| ELECTRICAL COMPONENT N | D2N |

**FIG. 8**

EP 4 450 333 A1

FIG. 9

**FIG. 10**

FIG. 11

FIG. 12

FIG. 13

**FIG. 14**

**FIG. 15**

## INTERNATIONAL SEARCH REPORT

| International application No. |
|---|
| **PCT/JP2022/046209** |

**A. CLASSIFICATION OF SUBJECT MATTER**

*B60R 16/04*(2006.01)i; *B60L 58/10*(2019.01)i; *B60R 16/023*(2006.01)i; *G01R 31/367*(2019.01)i; *G01R 31/371*(2019.01)i; *G01R 31/382*(2019.01)i; *G01R 31/385*(2019.01)i; *G01R 31/389*(2019.01)i; *G01R 31/392*(2019.01)i; *H01M 10/44*(2006.01)i; *H01M 10/48*(2006.01)i; *H02J 7/00*(2006.01)i; *H02J 13/00*(2006.01)i

FI: B60R16/04 W; B60R16/023 Z; B60L58/10; G01R31/367; G01R31/371; G01R31/382; G01R31/385; G01R31/389; G01R31/392; H01M10/44 P; H01M10/48 P; H01M10/48 301; H02J7/00 P; H02J7/00 U; H02J13/00 301A

According to International Patent Classification (IPC) or to both national classification and IPC

**B. FIELDS SEARCHED**

Minimum documentation searched (classification system followed by classification symbols)

B60R16/04; B60L58/10; B60R16/023; G01R31/367; G01R31/371; G01R31/382; G01R31/385; G01R31/389; G01R31/392; H01M10/44; H01M10/48; H02J7/00; H02J13/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2017-181206 A (THE FURUKAWA ELECTRIC CO., LTD.) 05 October 2017 (2017-10-05)<br>    paragraphs [0017]-[0081], fig. 1-11 | 1-21 |
| Y | JP 2020-38102 A (HONDA MOTOR CO., LTD.) 12 March 2020 (2020-03-12)<br>    paragraphs [0016]-[0093], fig. 1-11 | 1-21 |
| X | paragraphs [0016]-[0093], fig. 1-11 | 22 |
| Y | JP 2011-214843 A (THE FURUKAWA ELECTRIC CO., LTD.) 27 October 2011 (2011-10-27)<br>    paragraph [0054] | 2-21 |
| Y | JP 2018-202989 A (DENSO CORP.) 27 December 2018 (2018-12-27)<br>    paragraphs [0010], [0025] | 2-21 |

☑ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **21 February 2023** | **07 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/046209**

**C.    DOCUMENTS CONSIDERED TO BE RELEVANT**

| Category* | Citation of document, with indication, where appropriate, of the relevant passages | Relevant to claim No. |
|---|---|---|
| Y | JP 2020-153881 A (THE FURUKAWA ELECTRIC CO., LTD.) 24 September 2020 (2020-09-24)<br>    paragraphs [0020]-[0110], fig. 1-14 | 2-21 |
| Y | JP 2019-164969 A (THE FURUKAWA ELECTRIC CO., LTD.) 26 September 2019 (2019-09-26)<br>    paragraphs [0020]-[0043], fig. 1-6 | 2-21 |
| Y | JP 2017-511020 A (ROBERT BOSCH GMBH) 13 April 2017 (2017-04-13)<br>    paragraphs [0027]-[0037], fig. 1 | 8-21 |
| Y | JP 2003-517613 A (BAYERISCHE MOTOREN WERKE AKTIENGESELLSCHAFT) 27 May 2003 (2003-05-27)<br>    paragraphs [0008]-[0021], fig. 1-7 | 9-21 |
| Y | JP 2018-74204 A (NIPPON SEIKI CO., LTD.) 10 May 2018 (2018-05-10)<br>    paragraphs [0012]-[0022], fig. 1 | 9-21 |
| Y | JP 2004-38293 A (KABUSHIKI KAISHA TOSHIBA) 05 February 2004 (2004-02-05)<br>    paragraphs [0009]-[0020], fig. 1-4 | 12-21 |
| Y | JP 2017-210182 A (THE FURUKAWA ELECTRIC CO., LTD.) 30 November 2017 (2017-11-30)<br>    paragraphs [0016]-[0019], fig. 1, 2 | 13-21 |

Form PCT/ISA/210 (second sheet) (January 2015)

INTERNATIONAL SEARCH REPORT
Information on patent family members

International application No.

**PCT/JP2022/046209**

| Patent document cited in search report | | | Publication date (day/month/year) | Patent family member(s) | Publication date (day/month/year) |
|---|---|---|---|---|---|
| JP | 2017-181206 | A | 05 October 2017 | US 2019/0033391 A1 paragraphs [0047]-[0114], fig. 1-11<br>WO 2017/170621 A1<br>EP 3438683 A1<br>CN 108885242 A | |
| JP | 2020-38102 | A | 12 March 2020 | US 2020/0070684 A1 paragraphs [0030]-[0113], fig. 1-11<br>CN 110871709 A | |
| JP | 2011-214843 | A | 27 October 2011 | US 2013/0110429 A1 paragraph [0182]<br>WO 2011/118080 A1<br>EP 2551687 A1 | |
| JP | 2018-202989 | A | 27 December 2018 | (Family: none) | |
| JP | 2020-153881 | A | 24 September 2020 | (Family: none) | |
| JP | 2019-164969 | A | 26 September 2019 | (Family: none) | |
| JP | 2017-511020 | A | 13 April 2017 | WO 2015/106947 A1 p. 10, line 22 to p. 14, line 29, fig. 1<br>DE 102014200822 A<br>CN 105900448 A<br>KR 10-2016-0111382 A | |
| JP | 2003-517613 | A | 27 May 2003 | US 2003/0057770 A1 paragraphs [0019]-[0034], fig. 1-7<br>WO 2001/044825 A1<br>EP 1435524 A1<br>DE 19961311 A | |
| JP | 2018-74204 | A | 10 May 2018 | (Family: none) | |
| JP | 2004-38293 | A | 05 February 2004 | US 2004/0057199 A1 paragraphs [0018]-[0031], fig. 1-4<br>EP 1383027 A2 | |
| JP | 2017-210182 | A | 30 November 2017 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015182518 A
- JP 2021093359 A

- JP 4532416 B